Europäisches Patentamt

European Patent Office

Office européen des brevets

(11) Publication number: **0 081 007**

**B1**

(12) **EUROPEAN PATENT SPECIFICATION**

(45) Date of publication of patent specification: **20.08.86**

(51) Int. Cl.⁴: **H 01 L 39/22**

(21) Application number: **81110277.1**

(22) Date of filing: **09.12.81**

(54) Superconducting tunnel junction device.

(43) Date of publication of application:
**15.06.83 Bulletin 83/24**

(45) Publication of the grant of the patent:
**20.08.86 Bulletin 86/34**

(84) Designated Contracting States:
**DE FR GB IT**

(56) References cited:
**US-A-4 157 555**

**PHYSICS LETTERS, vol. 59A, no. 4, 13 December 1976, Amsterdam, I. IGUCHI et al. "Quasiparticle injection and disappearance of superconductivity in Superconducting tunneling junctions", pages 313-315 ELECTRONICS LETTERS, vol. 17, no. 14, July 1981, London, S. SAKAI et al. "Static characteristic of a new quasiparticle injected superconducting weak link device", pages 501-503**

(73) Proprietor: **International Business Machines Corporation
Old Orchard Road
Armonk, N.Y. 10504 (US)**

(72) Inventor: **Faris, Sadeg Mustafa
2316 Mark Road
Yorktown Heights, N.Y. 10598 (US)**

(74) Representative: **Schröder, Otto, Dr. Ing. et al
Säumerstrasse 4
CH-8803 Rüschlikon (CH)**

(56) References cited:
**IBM TECHNICAL DISCLOSURE BULLETIN, vol. 24, no. 7A, December 1981, New York, P.W. EPPERLEIN "Superconducting tunneling transistor with high current-gain", pages 3188-3190**

**Physical Review B, vol. 4, no. 7, 1 oct. 1971, L.R. Testardi, "Destruction of superconductivity", pp. 2189-2195**

Courier Press, Leamington Spa, England.

# Description

This invention relates to a three terminal superconducting tunnel junction device comprising three conducting electrodes which are separated from one another by two tunnel barriers to form two tunnel junctions. More particular, the invention concerns a superconducting device whose current-voltage characteristic is altered by heavy injection of excess quasi-particles. The device can be used for logic operations, or as an amplifier, and has an output that is sufficiently large to drive another such device.

Superconducting switching devices are well known in the art, and are represented by devices such as the cryotron and the Josephson tunneling device. In the cryotron, the superconducting gap of a film is caused to vanish (i.e., the film becomes normal). This can occur by several mechanisms, including passing a current through the film having a magnitude greater than the critical current of the film applying an external magnetic field, and by heating the film.

A Josephson tunneling device is one which exhibits a zero-voltage current between two superconductors separated by a very thin tunnel barrier. By increasing the current through the device, or by applying a magnetic field to the device, the device can be made to switch to a non-zero voltage state. However, the device remains superconducting at all times.

Another superconducting device is that represented by the transistor of U.S. 4,157,555. In that device three superconductors are separated from one another by two insulating layers to form two tunnel junctions. Depending on the biasing applied to these tunnel junctions, a change can result in the total current flow through one of the junctions, which change is greater than the amount of current injected into one of the superconductors. In this device, quasi-particles are injected into the middle electrode, but the number of quasi-particles injected is small. That is, the number is in the order of the number of thermally axcited quasi-particles in the superconductor. This means that the superconducting gap $\Delta$ of the superconductor into which the quasi-particles are injected remains near its equilibrium value. In that device, any change in $\Delta$ due to the quasi-particle injection is much less than 1% of its value at equilibrium.

The device of U.S. 4,157,555 cannot function as a switch in the digital sense. Because the superconducting gap remains near its equilibrium value, that device functions only as a small signal analog amplifier (even if the tunnel current density of its output junction is much greater than the tunnel current density of its input junction) and it is not possible to provide a sufficiently large output to drive another similar device. Stated another way, the output of that device is not sufficiently large to change the state of another such device being driven by it.

In the device of U.S. 4,157,555, the difference in tunnel resistance between the two tunnel junctions of the device is such that the device is restricted to small signal analog amplification. In that device, recombination times must be very long with respect to the tunneling rate, and for this reason aluminum is chosen as a representative superconductor. However, these materials are not favorable if large signal amplification is desired, or if it is desired to have a switch which has distinguishable output states and which can drive another such switch.

The transistor of U.S. 4,157,555 is not an inverter and cannot operate as a switch in a digital sense. Its collector junction is biased at an amount less than the gap voltage and for this reason, as well as the small number of quasi-particles injected, a small output results. At the present time, there is no known cryogenic switch which provides digital inversion, as can be obtained with semiconductor bipolar and FET devices.

The operation of the present device is based on *QU*asi-particle *I*njection *T*unneling, and hence is called QUITERON. It relies on heavy injection of excess quasi-particles in order to cause a superconducting gap to drastically change, and generally to vanish. It distinguishes from the experiments of Testardi, Phys, Rev. *B4*, 2189 (1971) in that a complete three terminal device is obtained capable of digital switching. In Testardi's experiments, he discovered that thin superconducting films can be irradiated by optical pulses to drive them into a normal state and back to the superconducting state very rapidly. Testardi suggested that an excess number of quasi-particles larger than the usual thermal equilibrium number were responsible for this phenomenon. However, no devices were suggested or described.

Non-equilibrium superconductivity is a subject of intense investigation, as represented by the work of Ginzberg, Phys. Rev. Lett., *8*, 204 (1962). In that reference, Ginzberg describes a double junction configuration used to measure quasi-particle recombination life-time. Still further, K. E. Gray, Appl. Phys. Lett., *32*, 392 (1978) reported measurement of small signal gain in a double junction configuration and found that, at an extremely low level of injection, its operation was analogous to that of a transistor. This operation is described more fully in the Gray patent previously referenced (U.S. 4,157,555).

The invention as claimed is intended to remedy the drawbacks hitherto encountered. In contrast with the prior art, a cryogenic switch usable for digital switching and large signal analog amplification is described. This switch uses heavy injection of excess energetic quasi-particles into a thin superconducting film, in order to drastically change the superconducting gap of this film. In most applications, the superconducting gap is driven to zero. This device can be used to switch other devices since it provides a large output, and can be used to build a NOR block. This NOR block can in turn be used to design all types of logic circuits, without the requirement for separate AND, OR, and INVERT circuits, as would be needed when using other types of cryogenic switches.

The present device is based upon the discovery of an unexpected threshold power density relationship in which the current-voltage characteristics of the device drastically change when the superconducting gap $\Delta$ changes by a large amount. This threshold power density relationship leads to a switch exhibiting high gain, inverting characteristics, high noise immunity, and high discrimination between its output states.

The superconducting device is comprised of a plurality of conducting layers which function as electrodes, there being tunnel barriers between the electrodes. A tunnel junction, termed an injector junction, is used to heavily inject excess quasi particles into a superconducting layer which is one electrode of a second tunnel junction, termed the acceptor junction. Due to the heavy injection of excess quasi particles, the current-voltage characteristics of the acceptor tunnel junction are changed. In this manner different voltage states are provided which are easily distinguishable from one another. This device can provide an inverting characteristic, and is the only known cryogenic device which has this property. Because of this, it can be used to design circuits, such as NOR blocks, which are similar to those designed with bipolar and FET devices.

Since the device is capable of a multiple number of output states which are clearly distinguishable from one another, it can be used as a switch. Due to the large output that results, one such switch can be used to drive another in order to make complete circuits comprised of these switches. An additional application is that of an analog amplifier in which analog signals can be greatly amplified. For this use, heavy injection of excess quasi particles is also required.

The modification of the tunneling properties of the acceptor junction depends on a heavy injection of an excess number of quasi particles. By "heavy", it is meant that the superconducting gap $\Delta$ of the superconducting layer comprising an electrode of the acceptor junction is drastically changed, and is usually driven to $\Delta=0$. The number of quasi-particles injected is greater than the usual thermal equilibrium number of quasi particles, and is typically at least two orders of magnitude greater than the number which would be produced by thermal excitation. In contrast with the superconducting transistor of U.S. 4,157,555, where the superconducting gap $\Delta$ changes by an amount much less than 1%, the superconducting gap $\Delta$ changes drastically in the present invention, and is generally driven to zero.

In the practice of this invention, it has been discovered that a threshold power density exists at which an excess quasi particle concentration causes the order parameter (superconducting gap) to locally vanish. Thus, when the present invention is used as a switch, the amount of power applied is at least of the order of the threshold power density, and generally exceeds that density, in order to change the state of the device. The superconducting electrodes, geometrical configuration, and type of load are chosen so that the output power of one device is sufficient to exceed the power density threshold of another identical device.

While the injector junction is generally comprised of a single tunnel barrier layer, multiple tunnel barrier layers can be used to provide multiple inputs to the injector. The injector tunnel barrier can be comprised of an insulator, a normal metal, a semi-metal, or even a semiconductor. On the other hand, the barrier layer used for the acceptor tunnel junction is generally an insulator, since the acceptor junction must evidence a sharp current transition in its current-voltage curve indicating two distinct superconductor gaps. The acceptor tunnel junction can be comprised of a plurality of tunnel junctions in series, or can be comprised of a single tunnel junction. As will become more apparent, the use of multiple junctions in series leads to a device with higher voltage outputs, and one which offers more flexibility in fabrication.

In still other embodiments, this superconducting device can switch from a Josephson current state (i.e., zero voltage state) to a non-zero voltage state. The mode of operation in this embodiment is non-inverting. In another mode of operation, a three-state device can be obtained in which one of the states is a Josephson current state, while the other states are non-zero voltage states. In this latter devices, the acceptor tunnel barrier does not have to be comprised of an insulating material, i.e., it can be a semiconductor, metal, or a semi-metal.

This superconducting device is capable of high gain (greater than about 10), is latching or non-latching (depending upon the biasing), and can be fabricated to provide dense arrays. In the operating modes where Josephson currents are not used, it will not exhibit resonance properties and also has a very low sensitivity to trapped flux. It exhibits high noise immunity and provides high discrimination between output states. The amount of energy required to switch it is extremely low, being of the order of $10^{-17}$ joules.

Different ways of carrying out the invention are described in detial below with reference to drawings which illustrate specific embodiments, in which:

Fig. 1.1 shows a known superconductor-insulator-normal metal structure for injection of quasi-particles into the superconductor.

Fig. 1.2 is a curve illustrating the dependence of the supercoducting gap on the excess quasi-particle density at $T=0°$. These curves are based on two models relating the superconducting gap to the excess quasi-particle density $\eta$.

Fig. 1.3 is a plot of the current $I_T$ through the superconductor-insulator-normal metal structure of Fig. 1.1 plotted as a function of the voltage $V_T$ across the structure of Fig. 1.1 and the voltage $V_{12}$

measured between two points in the superconducting layer.

Fig. 2.1 shows a structure comprising two superconductors $S_1$ and $S_2$ separated by a thin tunneling barrier, while Fig. 2.2 shows the expected dependence of threshold power density $P_c(\varepsilon)$ on injected quasi-particle energy $\varepsilon$.

Fig. 3.1 is an illustration of a structure including two superconductors $S_1$ and $S_2$ where quasi-particles are injected into $S_2$, while Fig. 3.2 shows the modification of the current-voltage (I-V) characteristics of the structure of Fig. 3.1 by heavy injection of quasi-particles such that $\Delta_2 \rightarrow 0$.

Fig. 4.1 illustrates a three terminal superconducting switch in accordance with the present invention in which a single junction acceptor (SJA) has its tunneling characteristics modified by excess injection of quasi-particles, there being a linear load $R_L$ connected across the acceptor junction.

Fig. 4.2 illustrates a superconducting switch in accordance with the present invention wherein two acceptor junctions in series have their tunnel characteristics modified by injection of excess quasi-particles into the acceptor junctions, there being a linear load $R_L$ connected across the series connection of acceptor junctions.

Fig. 4.3 shows the current-voltage (I-V) of the SJA and DJA structures of Figs. 4.1 and 4.2, and illustrates the "1" and "0" states produced across the resistive load $R_L$.

Fig. 5.1 shows two directly coupled Quiterons, where a first double junction acceptor has as a load a second double junction acceptor. The second DJA provides a nonlinear load to the first DJA, and the current-voltage characteristics of the first DJA are shown in Fig. 5.2.

Fig. 6 is another plot of the acceptor characteristics of a first DJA having a second DJA as a non-linear load, and is used to provide the definitions used for the derivation of gain and discrimination ratio, where one DJA Quiteron drives another DJA Quiteron, as shown in Fig. 5.1.

Fig. 7 is another plot of power density $P_c$ as a function of injected quasi-particle energy $\varepsilon$, show-ing the location of the binary states of the Quiteron, thereby indicating the enhancement of discrimination between the "1" and "0" states.

Fig. 8 illustrates a scheme for making electrical contact to the thin superconducting electrode $S_2$ whose gap is greatly modified by the introduction of excess quasi-particles. A DJA structure is shown in this side view.

Fig. 9 is a top view of the DJA structure of Fig. 8, showing a possible layout of this Quiteron device, where the superconducting layers are $S_1$, $S_2$ and $S_3$.

Fig. 10.1 shows a SJA Quiteron which can be used in a logic circuit, while Fig. 10.2 shows its current-voltage characteristic.

Fig. 11.1 shows a DJA Quiteron which can be used in a logic circuit, while Fig. 11.2 shows its current-voltage characteristics for this application.

Fig. 12 shows a DJA Quiteron circuit powered by current sources $I_{a1}$, $I_{a2}$, and $I_{a3}$, in order to obtain a fan-out of four.

Fig. 13 illustrates SJA Quiteron parallel powered logic circuits. This SJA Quiteron configuration avoids isolation problems encountered by DJA Quiteron circuits such as those in Fig. 12.

Fig. 14.1 shows a three-input NOR circuit using SJA devices, while Fig. 14.2 shows the curernt-voltage characteristic of this NOR circuit.

Fig. 15.1 shows a three-input NOR circuit using a SJA device which has a multi-injection input (i.e., the injector junction is comprised of a plurality of tunnel junctions).

Fig. 15.2 shows the current-voltage characteristic of the device of Fig. 15.1.

Fig. 16 shows a four-bit decoder using SJA devices, some (Q1—Q4) of which have single injector junctions, while others (Q5—Q20) have multi-injector junctions.

Fig. 17 shows a full adder using Quiteron NOR circuits, and which includes both single junction and multiple injector junction devices.

Fig. 18 shows a Quiteron flip-flop circuit, using double injector SJA Quiterons.

Fig. 19 shows the current-voltage characteristics of a DJA Quiteron used as an amplifier for amplifying analog signals.

Fig. 20.1 shows a SJA device using a different biasing scheme, while Fig. 20.2 shows the I-V characteristic of the device of Fig. 20.1.

Fig. 21.1 shows a Quiteron device with a linear load, while Fig. 21.2 shows its I-V characteristics, depending on different values of Stewart-McCumber hysteresis parameter $\beta$, and on different values of injected input power P, when the device switches from a Josephson state to another state.

Fig. 22 shows the I-V characteristics of the device of Fig. 21.1 when it is switched from a Josephson state to another state, where the load is now a non-linear load (such as another Quiteron device).

Fig. 23 shows the I-V characteristics of the device of Fig. 21.1 when it is biased to have three distinguishable states, one of which is a Josephson state.

The superconducting devices of the present invention rely on heavy injection of excess energetic quasi-particles to modify the gap $\Delta$ of a superconductor such that $\Delta \rightarrow 0$, thereby greatly altering the tunneling properties of an output (acceptor) tunnel junction. The device is specifically designed to provide sufficient output energy (voltage) to be able to drive another such device in order to change the tunnel characteristics of the driven device. That is, when used as a switch, the device must provide a useful output, where "useful" means that the output exceeds the threshold power of all the driven Quiteron devices in order to switch them to another state. Also, this device can provide inversion and non-latching properties, as well as high gain.

In a general sense, the provision of three terminal devices is desirable from a circuit design standpoint, and the present invention provides such devices. A first tunnel junction (injector junction) is provided for heavy injection of excess energetic quasi-particles into a superconductor which is one electrode of a second tunnel junction (i.e., output or acceptor junction). In addition to electrical excitation, optical, phonon, electron, ion, or neutron excitation, or any combination of these types of excitation can be used to inject excess energetic quasi-particles to make $\Delta \rightarrow 0$. As an example, a three terminal device can use a combination of electrical excitation and optical excitation to significantly change the gap of a superconductor in the device in order to change the tunneling characteristics of the output acceptor junction.

Thus, it is an important feature of the present invention to provide a superconducting device having a useful power output and for this reason the excitation is chosen in order to create a non-equilibrium state in the superconductor whose band gap is greatly modified by the heavy injection of quasi-particles. An excitation mechanism which leaves the superconducting gap near its equilibrium value is not useful when providing switching action in the digital sense (i.e., when providing a sufficient output to drive other similar devices).

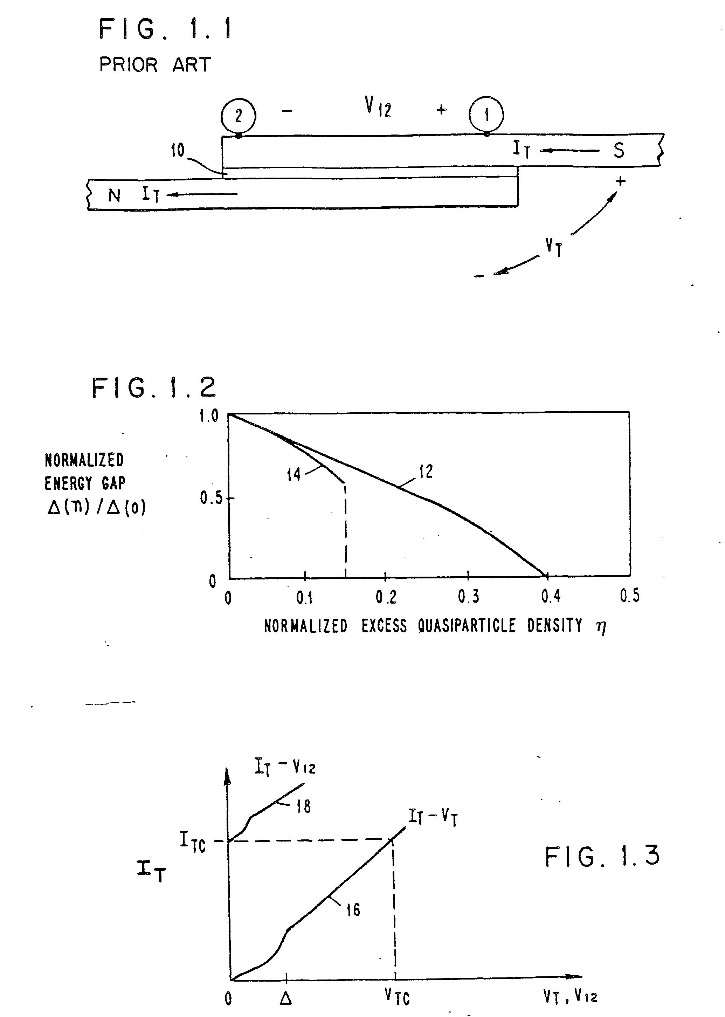

Theory of the invention (Figs. 1.1, 1.2, and 1.3)

A superconducting strip can be driven normal (resistive) by heating it to its critical temperature $T_c$ or by passing a current through the strip whose density exceeds the critical current density $j_o$. Another technique for driving the superconducting strip normal is to apply an external field greater than the critical field $H_c$. When the superconducting strip is driven from its superconducting state to a resistive state, the superconducting gap $\Delta$ disappears. This is true for both thin and thick superconducting strips, although the change in the gap varies at a different rate depending upon the film thickness. This is the basis for operating the known cryotron switch.

These mechanisms for driving a superconducting strip normal are equilibrium phenomena because the Cooper pairs, quasi-particles, and the phonoms involved are in thermal and chemical equilibrium with each other. For equilibrium situations, the energy distributions for the quasi-particles and phonons are given by the Fermi-Dirac and Bose-Einstein statistics, respectively. These equilibrium phenomena are well known in the field of superconductivity, and are explained more completely in the text by M. Tinkham "Introduction to Superconductivity" published by McGraw-Hill, 1975. The excess quasi-particles are created when energies greater than $2\Delta$ are applied so that free electrons and holes are created when the Cooper pairs are split.

It is possible to drive the superconducting strip far from equilibrium by means of overinjection of quasi-particles having energies greater than the gap $\Delta$. The energy gap vanishes as the quasi-particles and phonons assume distributions significantly different from those associated with their thermal equilibrium values. This overinjection of excess quasi-particles causes $\Delta$ to vanish. It is important to note that in this non-equilibrium excitation the films are still in the non-equilibrium superconducting state even though the gap vanishes. This, in turn, greatly modifies the tunneling characteristics of the device, bringing them far from that which would obtain at equilibrium. Still further, heavy injection can lead to a device output $>2\Delta$, which can be used to drive another similar device since it will produce energetic quasi-particles in the driven device.

In Fig. 1.1, a superconducting-insulator-normal conductor structure is shown. A tunnel barrier 10 is located between the normal conductor N and a superconductor S. Barrier 10 can be, for example, an oxide of the normal metal N. A current $I_T$ tunnels through barrier 10 and produces a voltage $V_T$ across the structure. The voltage $V_{12}$ is a voltage measured between points 1 and 2 on the superconductor S.

This SIN tunnel junction is a means by which quasi-particles can be injected into superconductor S. This is a known structure and is used to illustrate the injection of quasi-particles.

The tunneling current $I_T$ creates an excess quasi-particle number density

$$n=(N-N_T)/4N(0)\Delta(0)$$

of energy $eV_T$, where $N$ and $N_T$ are the non-equilibrium and equilibrium quasi-particle number densities, respectively, $N(0)$ is the Bloch density of state, and $\Delta(0)$ is the zero temperature gap. The excess density n increases as the injected power density

$$P=J_T V_T (J_T=I_T/\text{area})$$

is increased until threshold values $P_c$ and $n_c$ are reached such that $\Delta(n_c)$ vanishes. This is illustrated in Fig. 1.2.

Fig. 1.2 shows the dependence of the gap $\Delta$ (normalized) on the excess quasi-particle density (normalized) at $T=0°$. The top curve 12 is derived in accordance with the known BCS(T*) model, while the bottom curve 14 is derived from the known Owen-Scalapino $\mu^*$ model.

When the injected power density increases to $P_c=J_{Tc}V_{Tc}$, the voltage $V_{12}$ makes a transition from zero to a finite value. This is indicated in Fig. 1.3, which is a plot of the tunneling current $I_T$ as a function of the voltages $V_T$ and $V_{12}$. Thus, curve 16 applies when $P<P_c$, while curve 18 is for $P>P_c$. The threshold power density $P_c$ and its dependence on injected quasi-particle energy directly affect the characteristics of the Quiteron, since they determine the gain, power dissipation, and speed of this device.

The critical injection current density $J_{Tc}$ can be much smaller than the critical current density $J_c$ of the superconductor S. This distinguishes the non-equilibrium mechanism of the Quiteron and the equilibrium mechanism as far as gap suppression is concerned. The ratio $J_c/J_{Tc}$ is the absolute upper limit of the Quiteron gain. Another distinguishing factor is the speed of the non-equilibrium mechanism, which is much faster than that of the equilibrium mechanism.

As the external excitation is removed, i.e., the quasi-particle injection is stopped ($I_T\rightarrow 0$), and the gap recovers its equilibrium value $\Delta$ in a time (relaxation time) governed by several mechanisms. These mechanisms include inelastic scattering, recombination of holes and electrons with the emission of phonons at $n\omega > 2\Delta$, phonon escape from the superconductor, and quasi-particle diffusion. These mechanisms also influence the critical power density.

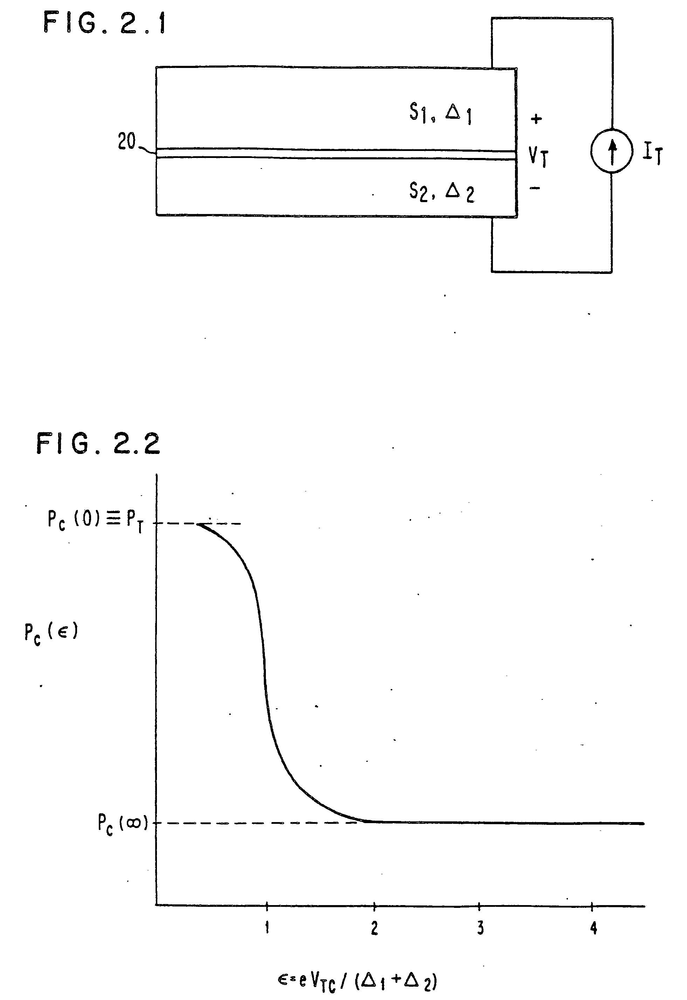

Threshold power density (Figs. 2.1 and 2.2)

At the critical excess quasi-particle density $n_c(P_c)$, the gap $\Delta$ will vanish. The threshold power density is therefore the density which is required to observe the voltage $V_{12}$. It should be noted that in the transistor of U.S. 4,157,555, the gap $\Delta$ remains at its equilibrium value or very near to it (i.e., the change in $\Delta$ is $\ll 1\%$) and the voltage $V_{12}$ is not observed. The output voltage of that device is intended to be $<2\Delta$ and its current-voltage characteristics remain substantially the same. In turn, this means that a switching device useful for logic applications cannot be obtained, nor can an amplifier having linearity with large gain.

The following expression has been derived for the threshold power density $P_c$ at $T\approx 0$:

$$(1) \qquad P_c = \frac{4.8e\Delta(0)d}{\pi^2 F\tau}\left(\frac{kT_c}{nc_s}\right)^3$$

where $c_s$ is the speed of sound, F is the fraction of energy converted to quasi-particles, d is the thickness of the electrode $S_2$, e is the charge of an electron, $T_c$ is the critical temperature, k is the Boltzman constant, and $\tau$ is the thermalization time. The parameter d has a lower limit set by the coherence length and the proximity effect which tend to decrease the gap from its bulk value. The thermalization time $\tau$ also depends on the thickness through the phonon escape mechanism from the film into the surroundings.

It is known that $P_c$ does not change as a function of injected voltage $V_{Tc}$, which is a valid assumption for $V_{Tc} \gg 2\Delta$. This has been experimentally verified in lead-tin junctions over a wide voltage range. The dependence of $P_c$ on the injected quasi-particle energy is expected to rise very sharply at the normalized quasi-particle energy

$$\varepsilon = eV_{Tc}/(\Delta_1 + \Delta_2),$$

as shown in Fig. 2.2 for two superconductors $S_1$ and $S_2$ having gaps $\Delta_1$ and $\Delta_2$, respectively. This structure and the tunnel barrier 20 therebetween are shown in Fig. 2.1.

The film $S_2$ is thin enough so that its gap $\Delta_2$ vanishes at $P_c$, while superconductor $S_1$ is much thicker and consequently is not affected by $P_c$.

The sharp rise of $P_c$ at $\varepsilon \sim 1$ is expected to occur due to the very sharply peaked densities of states at the gap edges of both materials. At $\varepsilon < 1$, $P_c$ saturates to the thermal power density $P_T \equiv P_c(0)$, because the only phonons that will destroy superconductivity are those provided by heating the film to $T_c$. The other extreme, $\varepsilon > 1$, exhibits a value $P_c(\infty)$ which takes the value given by Equation (1). In this case, the injected quasi-particles recombine with the emission of phonons at energies greater than $2\Delta_2$, which in turn break pairs in a time faster than they can escape from the film. At $T=0$, $P_c$ is expected to rise sharply to a value $P_T(0)=25.6\, d/\tau$ watt/cm$^2$, for lead, where d is in lengths of nm and $\tau$ is in pico-seconds.

The discovery of the $P_c vs. \varepsilon$ threshold relationship shown in Fig. 2.2 led to the recognition that a digital switch with an inversion property could be conceived in which the output would be sufficient to drive other similar switches, and which would exhibit high gain. This invention restricts the current density of the injector such that $P_c$ is reached at output voltages of approximatley $2(\Delta_2 + \Delta_3)$. This determines the choice of device materials, film thickness, and operating temperature in order to realize an inverting device having sufficient gain and capable of switching similar devices. The $P_c vs. \varepsilon$ relationship is not suggested from the prior art, and particularly from U.S. 4,157,555. The device of that patent is restricted in output voltage, current levels, and choice of materials such that the gap is not affected. Therefore, the advantages of high gain, etc. are not possible.

The importance of the power in the Quiteron action is that it is a threshold quantity, i.e., when $P_c$ is reached the gap vanishes. Large currents alone, or large voltages alone, do not necessarily cause the gap to vanish. An excessive amount of current will be required if an equilibrium phenomenon is relied upon. In this situation, the critical current of the film itself must be exceeded and no pair breaking will occur until the critical current is exceeded. However, in the non-equilibrium situation caused by heavy injection of high energy quasi-particles, less power is required to have the gap $\Delta$ to vanish to 0 in accordance with the relation shown in Fig. 2.2. The amount of voltage which is applied is sufficient to observe pair breaking, the minimum voltage being $2\Delta$. The applied voltage is chosen to be sufficient to sustain the gap at $\Delta=0$ as long as that is required. Thus, voltages are applied such that Cooper pairs break, and so that the gap vanishes. Relatively lower injected current and relatively lower voltage [$\gtrsim (\Delta_1 + \Delta_2)$] result in small power capable of making $\Delta_2 \rightarrow 0$. The energy of the injected quasi-particles and the number injected is sufficient to make a significant change in the gap $\Delta$. Non-equilibrium phonomena are utilized, and the output voltages are sufficiently high that similar Quiteron-type devices can be driven.

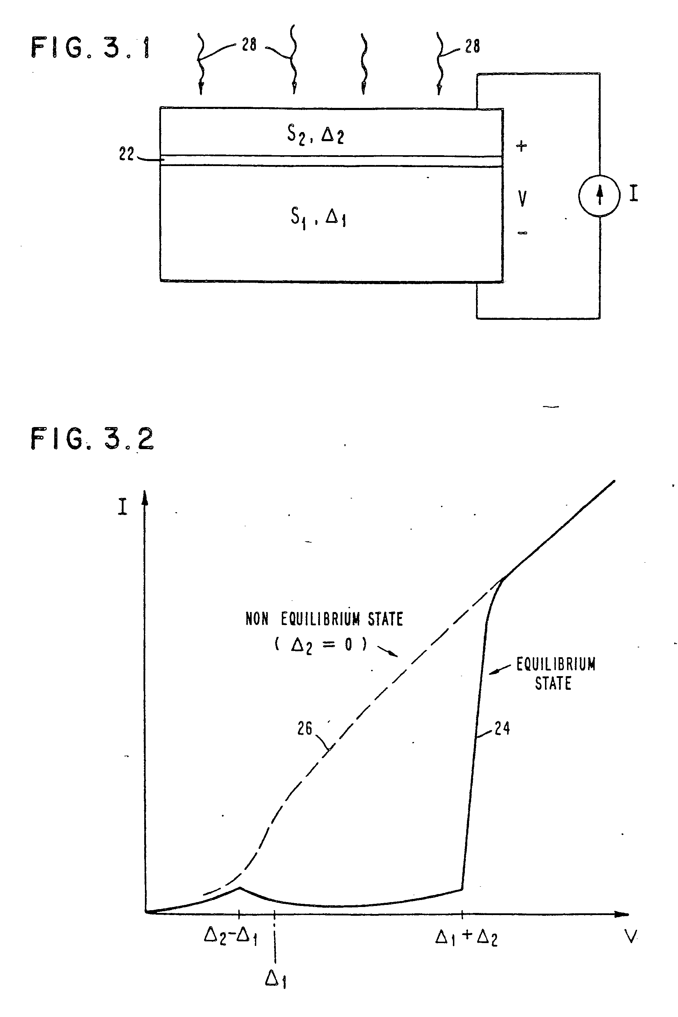

I-V Characteristics (Figs. 3.1 and 3.2)

Fig. 3.1 shows a structure comprising first and

second superconductors $S_1$ and $S_2$, having gaps $\Delta_1$ and $\Delta_2$, respectively, and separated by a tunneling barrier 22. A tunnel current I flows through the tunnel barrier, and a voltage V is established across the barrier.

The current-voltate (I-V) characteristics of the tunnel junction in Fig. 3.1 are shown in Fig. 3.2. The solid curve 24 is that due to an equilibrium state where $P \ll P_c$. As will be more apparent later, curve 24 must be one in which a current transition occurs at $\Delta_1 + \Delta_2$. This feature is required for the equilibrium I-V characteristic of the acceptor junction. The dashed curve 26 corresponds to that which occurs when P is greater than $P_c$ (i.e., $\Delta_2 \rightarrow 0$). The modified non-equilibrium curve 26 resembles that of a normal-superconductor junction which has a sharp current rise at $V = \Delta_1$.

When the threshold power density $P_c$ is achieved, the I-V characteristic changes from curve 24 to curve 26. When P is removed, the tunnel device switches back to the I-V curve 24. The ability to switch back and forth between curves 24 and 26 is referred to as the Quiteron action. This action can be achieved by the following different external excitations:

1. Creation of quasi-particles in electrode $S_2$ by photons having energies larger than $2\Delta_2$ such that Cooper pairs can be broken.

2. Phonon beams with $\hbar\omega > 2\Delta_2$.

3. Injection of quasi-particles by means of another tunnel junction.

4. Electron, ion, and neutron beam.

In Fig. 3.1, the arrows 28 represent the application of injected quasi-particles into superconductor $S_2$, as for example by photon beams.

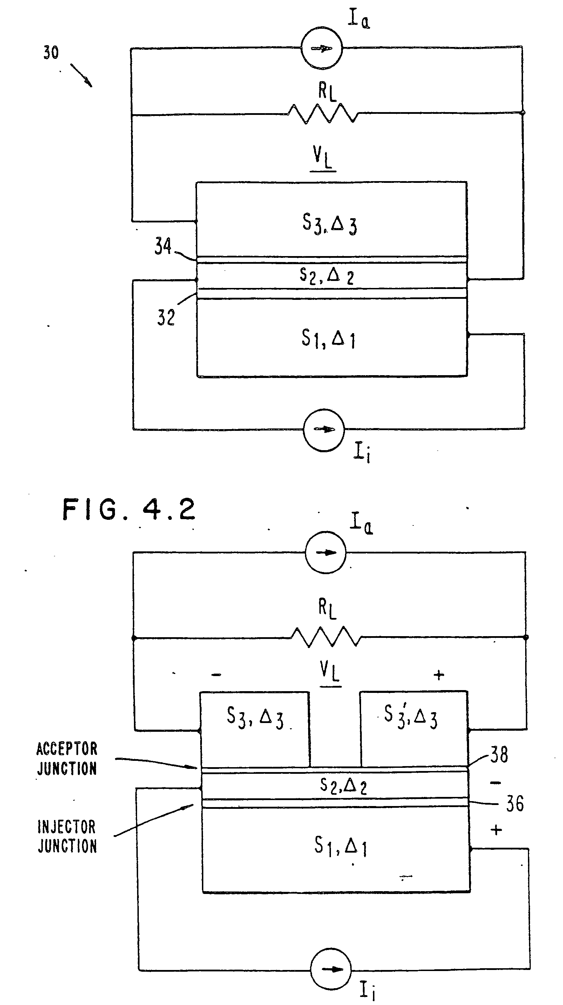

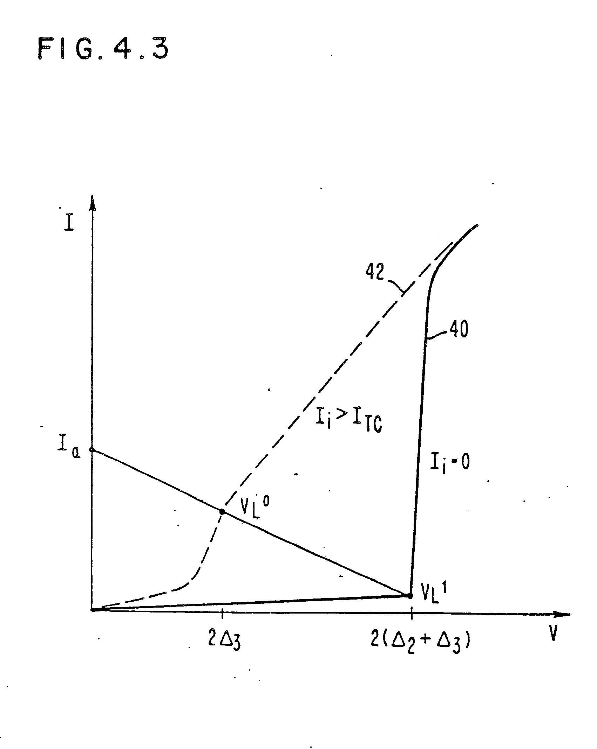

Quiteron embodiments (Figs. 4.1, 4.2, and 4.3) The Quiteron devices of Figs. 4.1 and 4.2 illustrate embodiments wherein the injection of quasi-particles is by means of another tunnel junction, which will be called the injector junction. As an alternative the injector could be a weak link device. In Fig. 4.1, the output junction (acceptor junction) is comprised of a single junction and the device is termed a single junction acceptor (SJA). In Fig. 4.2, the output junction is comprised of two junctions in series and the device is called a double junction acceptor (DJA). As will be seen later, the design of the DJA has advantages over the SJA design, particularly in the choice of the electrodes, and in the greater output voltage that can be obtained.

In Fig. 4.1, the Quiteron device 30 is comprised of three superconducting films $S_1$, $S_2$, and $S_3$, having gaps $\Delta_1$, $\Delta_2$, and $\Delta_3$, respectively. As will be seen later, maximum discrimination between binary 1 and 0 states, and the ability to drive other devices, occurs if certain relationships exist between $\Delta_1$, $\Delta_2$, and $\Delta_3$. Adjustment of these gaps relative to one another also affects the gain that can be obtained.

Middle electrode $S_2$ is made thin enough so that its gap $\Delta_2$ can be suppressed to zero when the threshold power density $P_c$ is exceeded. Films $S_1$ and $S_3$, on the other hand, are thick enough to prevent them from going normal when $P_c$ is exceeded.

A tunnel barrier 32 is formed between $S_1$ and $S_2$, and a second tunnel barrier 34 is formed between $S_2$ and $S_3$. Tunnel junction 32 is termed the "injector" junction since its function is to inject quasi-particles into superconductor $S_2$. Junction 34 is termed the "acceptor" junction since its tunneling characteristics will be modified depending upon the injection of quasi-particles into $S_2$.

In the operation of this device $S_1$ can be a non-superconductor (i.e., normal) or it can go normal, without adversely affecting device operation. $S_2$ must be a superconductor whose gap can be drastically reduced, and is sufficiently thin that a reasonable input power can be used to do that. $S_3$ is preferably a thicker superconductor, since the device is faster if only $S_2$ has its gap drastically changed when $P > P_c$ is applied. If $S_3$ stays superconducting, then two distinct states are achieved and only $S_2$ has to return to its original $\Delta_2$ state when the input power is removed. This means that switching between the different output states will be faster.

In Fig. 4.1, electrode $S_3$ is a continuous electrode across the entire lateral extent of barrier 34. Thus, the device is a single junction acceptor.

The injector and acceptor junctions are biased with DC current sources $I_i$ and $I_a$, and a load $R_L$ is connected across the acceptor junction formed by electrodes $S_2$ and $S_3$ having tunnel barrier 34 therebetween. The voltage across $R_L$ is $V_{L}$.

Fig. 4.2 shows a double junction acceptor in which two acceptor junctions are in series. In this device, superconductors $S_1$, $S_2$, and $S_3$ are provided having gaps $\Delta_1$, $\Delta_2$, and $\Delta_3$, respectively. $S_1$ and $S_2$ are separated by a tunnel barrier 36, while superconductors $S_2$ and $S_3$ are separated by tunnel barrier 38. $S_2$ is sufficiently thin that its gap $\Delta_2$ can be suppressed to zero when $P_c$ is exceeded, while films $S_1$ and $S_3$ are sufficiently thick that they will not go normal when $P_c$ is applied. The same considerations with respect to $S_1$, $S_2$, and $S_3$ described for the SJA structure of Fig. 4.1 apply to the structure of Fig. 4.2. The DC bias sources $I_i$ and $I_a$ are also the same as those described with respect to Fig. 4.1, as is the linear load $R_L$.

In the embodiment of Fig. 4.2, the acceptor junction is comprised of two tunnel junctions in series. One of these is formed between $S_3$ and $S_2$, while the other is formed between $S_3'$ and $S_2$. As was previously mentioned, the use of at least two junctions in series for the acceptor junction leads to a Quiteron whose output voltage is $> (\Delta_1 + \Delta_2)$ and hence it can drive another Quiteron device. In the SJA, greater constraints exist on the electrode materials in order to achieve the same results.

Fig. 4.3 shows the current-voltage characteristics (I-V) of the Quiterons of Figs. 4.1 and 4.2 across the linear resistive load $R_L$. When the injector bias $I_i = 0$, the load intersects the solid I-V curve 40 at a load voltage $V_L^1 = 2(\Delta_2 + \Delta_3)$. This

represents the binary state "1" of the output current $I_L$ through $R_L$.

If the injection current $I_i$ is increased such that the injected power $P_i = I_i V_i$ exceeds the threshold power $P_c x$ area, the gap $\Delta_2$ will vanish and the load line will intersect the dashed curve 42 at a load voltage $V_L^0 \simeq 2\Delta_3$. This is the "0" binary state of the Quiteron. Thus, the Quiteron can be used as an inverter, which is a feature exhibited by transistors. It operates in a non-latching mode because it can be switched back to the "1" state when $P_i \rightarrow 0$ (i.e., it does not stay in the $V_L^0$ state when $P_i = 0$).

In the practice of this invention, it is important that the acceptor junction exhibit an equilibrium I-V curve which has a current transition at $V = \Delta_2 + \Delta_3$, i.e., it must exhibit a two gap characteristic. For this reason, the acceptor tunnel barrier is generally an insulating material, such as an oxide of $S_2$. The injector tunnel barrier can be more arbitrarily selected and can be, for instance, a normal metal, a semi-metal, an insulator, a semi-conductor, etc. Although layered structures have been shown for the SJA and DJA devices, other geometries can be used. For example, the acceptor junction and/or the injector junction can be an edge junction.

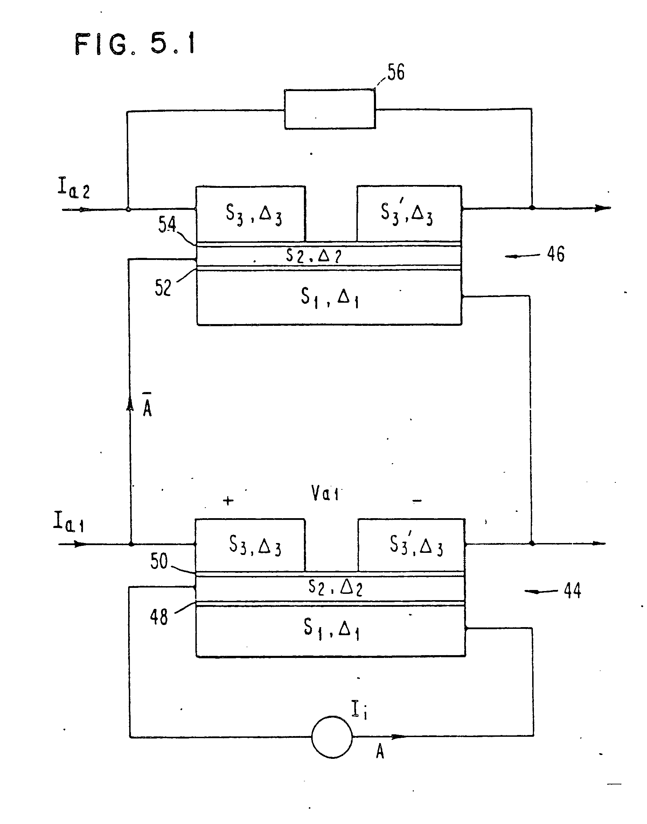

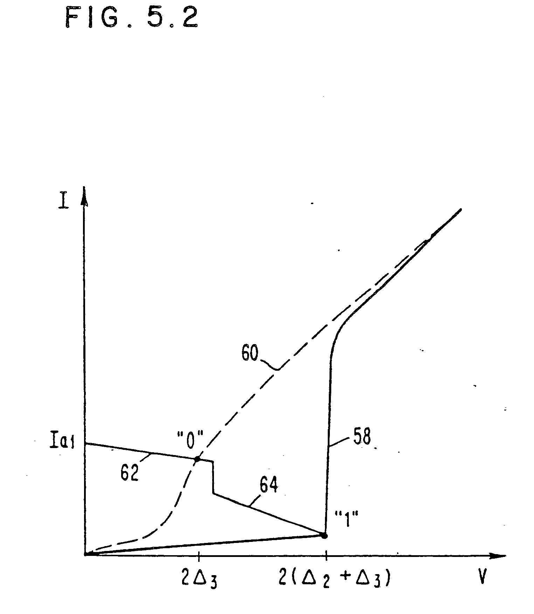

Directly coupled quiterons (Figs. 5.1 and 5.2)

For a useful device, it must be possible to apply the output of one Quiteron to drive another Quiteron, so that circuits comprising a plurality of Quiterons can be formed. It is a primary object of this invention to describe such a device, in order to provide useful logic and amplifier circuits.

Fig. 5.1 shows two directly coupled DJA Quiterons. In this circuit, the output of the first Quiteron 44 is used to drive the input of the second Quiteron 46. The injector junction of Quiteron 46 represents a nonlinear load to the output of Quiteron 44. As will be more apparent with respect to Fig. 5.2, this provides a nonlinear load line leading to a circuit having very good discrimination between different output states.

In more detail, Quiteron 44 is comprised of electrodes $S_1$, $S_2$, and $S_3$, having superconducting gaps $\Delta_1$, $\Delta_2$, and $\Delta_3$, respectively. Tunnel barrier 48 is provided between $S_1$ and $S_2$, while tunnel barrier 50 is provided between $S_2$ and $S_3$, as well as between $S_2$ and $S_3'$. Typically, $S_3$ and $S_3'$ are comprised of the same material.

Quiteron 46 is also comprised of three electrodes having the same designations $S_1$, $S_2$, and $S_3$. The superconducting gaps are $\Delta_1$, $\Delta_2$, and $\Delta_3$. Superconductor $S_3'$ is typically the same as $S_3$, and therefore also has the gap $\Delta_3$. Tunnel barriers 52 and 54 are provided in the same manner as tunnel barriers 48 and 50.

In a typical circuit, the materials comprising electrodes of Quiteron 46 will be the same as the material providing the electrodes in Quiteron 44. Additionally, the tunnel barriers 48 and 50 will be comprised of the same material as tunnel barriers 52 and 54, and will be formed at the same time.

A current $I_i$ is provided to the injector of Quiteron 44, and is designated as input A. Since the Quiteron is an inverter, the output of Quiteron 44 is $\overline{A}$. The acceptor junction 50 of Quiteron 44 is biased with DC current $I_{a1}$ while the acceptor junction 54 of Quiteron 46 is biased with DC current $I_{a2}$. A load 56 is provided across Quiteron 46.

It is possible for Quiteron 44 to drive Quiteron 46 since the gain of Quiteron 44 is sufficiently high that its output power in the "1" state, $P_1$, exceeds the threshold power of Quiteron 46, while that of the "0" state, $P_0$, does not. Quiteron 46 represents a nonlinear load to Quiteron 44 and this results in a significant increase in the discrimination ratio $D \equiv P_1/P_0$ between the "1" and "0" states. In order to take full advantage of this nonlinear loading, the condition

$$2\Delta_3 < \Delta_1 + \Delta_2 < 2(\Delta_2 + \Delta_3)$$

is satisfied.

The discrimination ratio is then given by:

$$(2) \quad D = \left( \frac{\Delta_2 + \Delta_3}{\Delta_3} \right)^2 (R_i/R_{NN}) \text{ injector}$$

$$= \left( \frac{\Delta_2 + \Delta_3}{\Delta_3} \right)^2 [1 + 1.43 V_m/(\Delta_1 + \Delta_2)]$$

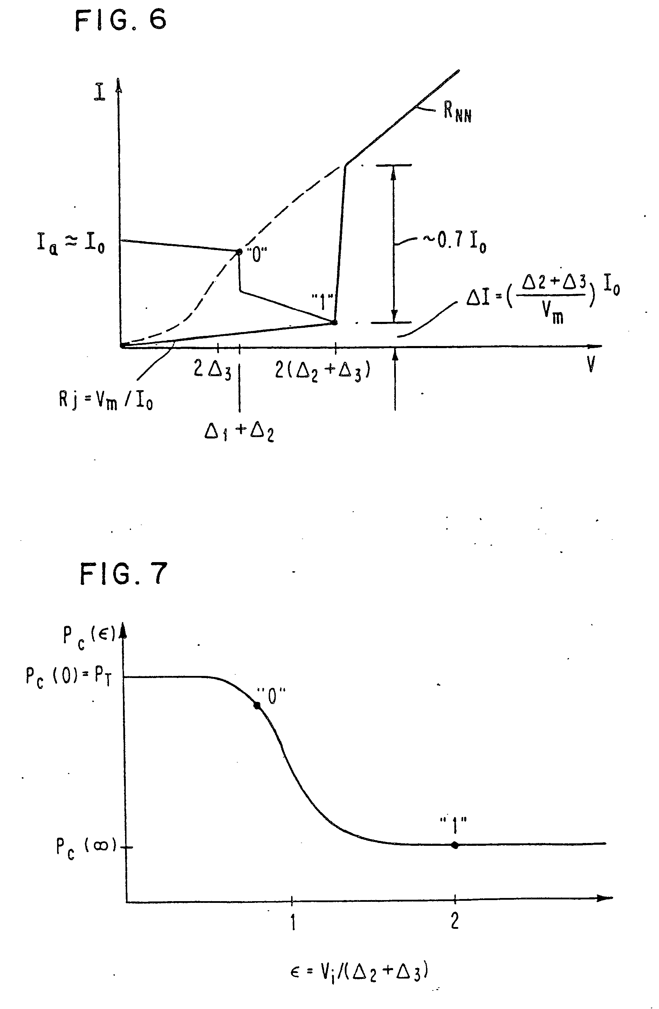

where $R_i$, $V_m$, $R_{NN}$ are defined in Fig. 6, and $I_0 \simeq 0.7(\Delta_2 + \Delta_3)/R_{NN}$. $R_{NN}$ is the normal tunnel resistance, and $V_m$ describes the quality of the junctions which ranges between 25 mV and 50 mV for lead alloy junctions. The leakage current

$$\Delta I \simeq \frac{(\Delta_2 + \Delta_3)}{V_m} I_0$$

is preferred to be as low as possible, and $R_i = V_m/I_0$.

Fig. 5.2 shows the I-V characteristics of the acceptor junction 50 with the nonlinear load represented by Quiteron 46. The solid curve 58 is the curve followed when the input excitation to Quiteron 44 is less than the threshold power density, while the dashed curve 60 is the I-V characteristic when the threshold power density of Quiteron 44 is exceeded such that $\Delta_2$ vanishes. The load line has two portions: A first portion 62 representing a high resistance and a second portion 64 representing a lower resistance. The binary "1" state occurs where the load line intersects solid curve 58, while the "0" state occurs where the load line intersects dashed curve 60.

Discrimination enhancement (Figs. 6 and 7)

Fig. 6 is a I-V plot of the acceptor characteristics of Quiteron 44 when the load for this Quiteron is a nonlinear load, and in particular is Quiteron 46. Fig. 6 is essentially the same as Fig. 5.2, except that it is used to define the parameters which are used to derive the expressions for the discrimination ratio (Equation 2) and for the gain of the device (Equation 7). As was described with respect to Fig. 5.2, $2\Delta_3$ is less than $\Delta_1+\Delta_2$, which in turn is less than $2(\Delta_2+\Delta_3)$. The binary "1" state is

$$V_L^1=2(\Delta_2+\Delta_3),$$

while the binary "0" state is $V_L^0=\Delta_1+\Delta_2$.

Fig. 7 is a plot of the threshold power density $P_c$ as a function of the normalized quasi particle energy

$$\varepsilon=V_i/(\Delta_2+\Delta_3).$$

Fig. 7 shows the location of the binary states with respect to the threshold power density curve, and is used to indicate the enhancement of discrimination when a nonlinear load is applied to Quiteron 44. The binary "0" state is at

$$\varepsilon_0=2\Delta_3/(\Delta_2+\Delta_3)<1,$$

while the binary "1" state is at $\varepsilon_1=2$. Equation 2 for the discrimination factor D has to be multiplied by the ratio $P_c(0)/P_c(\infty)$ to obtain

$$(3) \qquad D=\frac{P_c(0)}{P_c(\infty)}\left(\frac{\Delta_2+\Delta_3}{\Delta_3}\right)^2 [1+1.43V_m/(\Delta_1+\Delta_2)].$$

For $P_c(0)/P_c(\infty)=23.8$, and for $V_m=30\text{mV}$, $\Delta_1=\Delta_2=1.2\Delta_3=1.36\text{mV}$, $D=1932$.

The fact that discrimination occurs between power levels instead of between either voltage alone or current alone is a unique feature of the Quiteron. This has a significant impact on noise immunity, which can be described by a noise discrimination ratio $D_N$:

$$(4) \qquad D_N=\frac{P_c(0)}{P_c(\infty)}\ \frac{P_1}{P_{\text{Noise}}}=4\frac{P_c(0)}{P_c(\infty)}\left(\frac{\Delta_2+\Delta_3}{V_N}\right)^2\ \frac{Z_0}{R_{NN}}$$

where $V_N$ is the cross-talk noise induced in the line of impedance $Z_0$. For example, if $V_N=\Delta_2+\Delta_3$ and $Z_0=R_{NN}$, $D_N$ as high as 96 may be obtained.

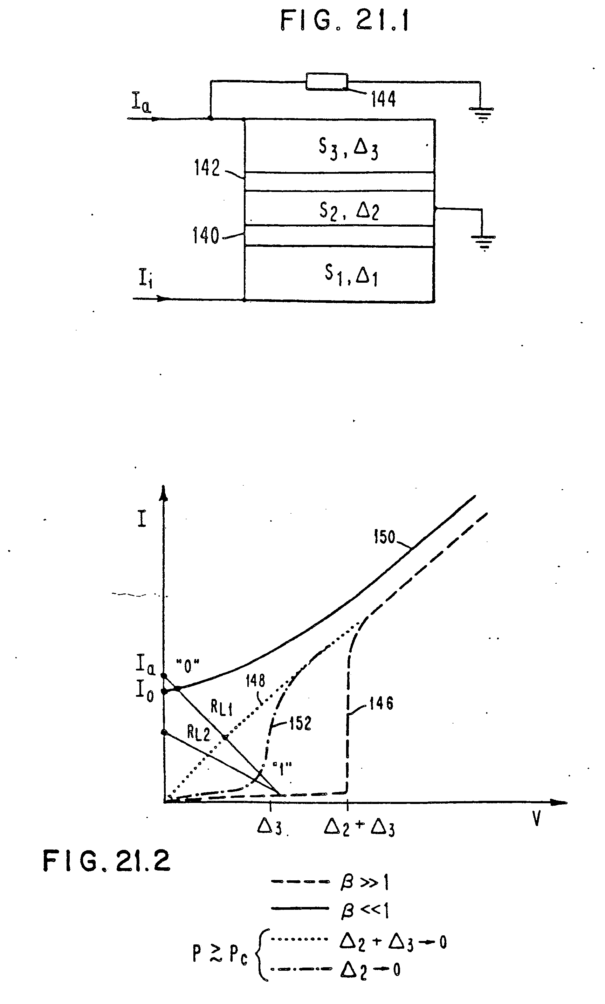

The Quiteron devices do not require the presence of Josephson tunneling current through the tunnel barriers. Therefore, resonance problems do not arise and these devices are not ultrasensitive to trapped flux. However, Josephson current can be present, as will be explained with respect to the embodiments of Figs. 21.1, 21.2, 22, and 23.

Gain

The power gain G of the Quiteron is the ratio of the output power across the load

$$P_L=2I_a(\Delta_2+\Delta_3)$$

to the injected threshold power $P_cA_i$ where $A_i$ is the injector junction area. This gain is given by the following expression:

$$(5) \qquad G=\frac{2I_a(\Delta_2+\Delta_3)}{P_cA_i}$$

Let $I_a\simeq1/2j_aA_a$, and

$$P_c=4j_i(\Delta_2+\Delta_3),$$

and assuming that $j_i$ is approximately $1/2j_{TC}$ and

$$D_{TC}=2(\Delta_2+\Delta_3),$$

the gain can be rewritten as

$$(6) \qquad G=\frac{A_a}{A_i}\ \frac{j_a}{4j_i}$$

The acceptor current density $j_a$ and the injector current density $j_i$ are measured at the same voltage $(\Delta_2+\Delta_3)$. Equation 6 indicates that by increasing the current density ratio it is possible to obtain $G\gg1$. It also indicates that the gain does not depend on the lateral dimensions of the Quiteron, but instead depends upon the tunnel barrier thicknesses.

Hence, the Quiteron device is potentially miniaturizable. For example, for $j_a/j_i=100$, the tunnel barrier thicknesses of the acceptor and injector barriers differ by merely 3 angstroms. In the Quiteron, the ratio $J_a/J_i$ is not arbitrarily chosen; instead, $j_i$ is chosen such that

$$J_i(\Delta_1+\Delta_2)\simeq P_c.$$

Gain is then defined after the threshold is reached. In contrast with this, the ratio $j_a/j_i$ in the transistor of U.S 4,157,555 is arbitrarily chosen.

Gains of 10 are easily realized using lead based alloy electrodes and an acceptor junction area which is 1/2 the injector junction area, and for $j_a=14,600\ \text{A/cm}^2$. If the ratio $j_a/j_i$ is increased, more gain is possible. Since tunnel current densities as high as $2\times10^5\ \text{A/cm}^2$ have been realized in lead alloys, this seems possible. However, there are fundamental limitations wihch fix the maximum gain $G_{max}$. For example, it is desirable to keep $j_a$ low enough that

$$\Delta I(\Delta_2+\Delta_3)\lesssim P_c(1),$$

using the I-V characteristic of Fig. 6. $G_{max}$ is given by the following expression:

$$(7) \qquad G_{max}=\frac{2I_a(\Delta_2+\Delta_3)}{\Delta I(\Delta_2+\Delta_3)}\ \frac{P_c(0)}{2P_c(\infty)}$$

It has previously been mentioned that it is advantageous to fabricate the acceptor from at least two junctions in series rather than from only one junction (SJA). One reason for this is the following. More flexibility is obtained in choosing the superconducting materials used for the electrodes in the case of a DJA than for an SJA because of the conditions imposed on the gaps. These conditions are

$$2\Delta_3 < \Delta_1 + \Delta_2 < 2(\Delta_2 + \Delta_3)$$

for a double junction acceptor, and

$$\Delta_3 < \Delta_1 + \Delta_2 < \Delta_2 + \Delta_3$$

for a single junction acceptor. For example, the convenience of using three identical superconductors $\Delta_1 = \Delta_2 = \Delta_3$ is possible in a double junction acceptor while still benefiting from the ratio

$$P_c(0)/P_c(\infty) \gg 1.$$

This ratio enters into the discrimination ratio expression given in Equation 3, and in the noise immunity Equation 4, as well as in the expression for maximum gain (Equation 7). In contrast with this, it is not possible to benefit from the ratio $P_c(0)/P_c(\infty)$ when $\Delta_1 = \Delta_2 = \Delta_3$ in the single junction acceptor Quiteron. Still further, the output voltage of the DJA is $2(\Delta_2 + \Delta_3)$, while for the SJA it is $(\Delta_2 + \Delta_3)$. The SJA benefits from the ratio $P_c(0)/P_c(\infty)$ if the constraint

$$\Delta_3 \lesssim \Delta_1 + \Delta_2 < \Delta_2 + \Delta_3$$

is imposed.

Miniaturization

Since the gain as given by Equation 6 does not depend upon the lateral dimensions of the Quiteron, advanced lithographic techniques and processes can be used to miniaturize these devices. At small line widths, the gain will be affected by the quasi-particle diffusion length. Since the operation of this device is based on overinjection of quasi-particles, the diffusion length decreases to about 100 nm, which is assumed to fix the smallest line width.

Speed

The non-equilibrium phenomena used to change the state of this device provides quite high switching speeds. In particular, superconductors having high $T_c$, and their alloys, should have the shortest quasi-particle relaxation times. The most dominant relaxation processes are recombination to form a bound Cooper pair with the emission of a phonon, and inelastic scattering with phonons. The recombination times and inelastic times become shorter at higher energies, which further proves the significance of the double junction acceptor embodiment. With overinjection of quasi-particles, there is an enhanced probability for recombination, which in turn produces more phonons to engage in the inelastic scattering process. If these phonons are sufficiently energetic, they will break additional Cooper pairs, to create even more quasi-particles. This helps to sustain the gap at $\Delta = 0$.

Power dissipation

From a power dissipation point of view, it appears that very low switching energies are required to change the state of the Quiteron. The absolute power dissipation per bit drops rapidly as $1/W^2$ for these devices, where W is the linewidth. For example, if a device has a switching speed less than about 100 psec., then at $W = 1$ micrometer, approximately $6 \times 10^{-18}$ joules (gain = 1) will be required to switch from one binary state of the device to the other.

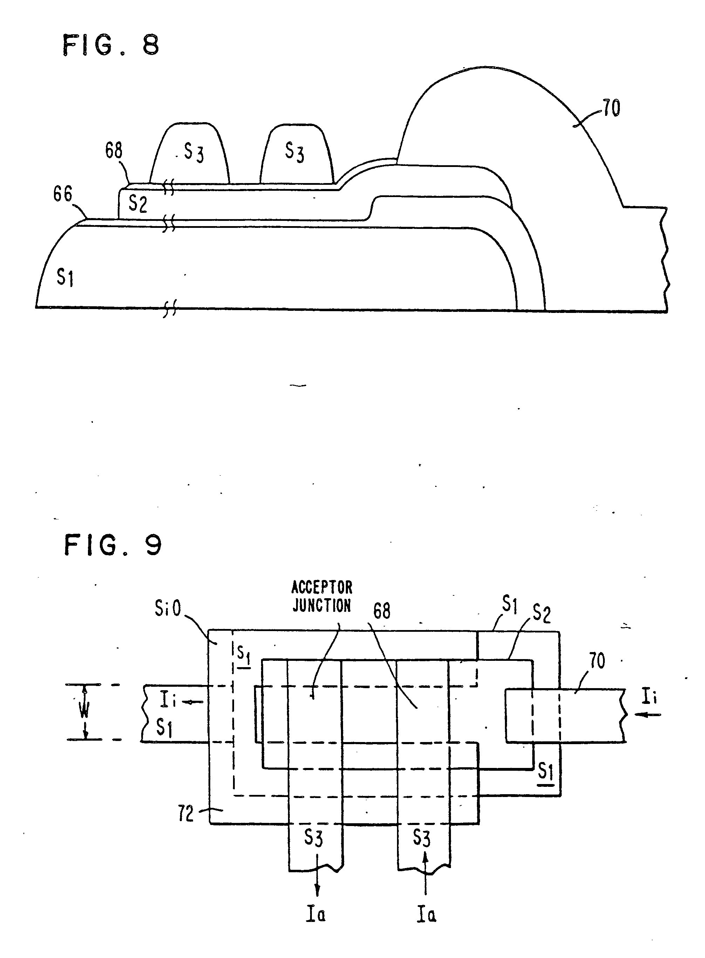

Fabrication (Figs 8 and 9)

The three electrode devices shown herein use a very thin superconductor $S_2$ whose gap is modified by overinjection of quasi-particles. Electrical contact must be made to this very thin electrode. Additionally, the electrodes $S_1$ and $S_3$ are thicker, and this means that the thin middle electrode $S_2$ has to step down a thick electrode $S_1$. Fig. 8 shows a scheme for making electrical contact to the thin electrode $S_2$.

In more detail, Fig. 8 shows the electrodes $S_1$, $S_2$, and $S_3$, which are separated by the injector barrier 66 and acceptor barrier 68. As is apparent, the injector junction 66 is thinner in the region where the Quiteron action occurs, but is thicker in the region where electrical contact is to be made to $S_2$. The thick metallurgical layer 70 is used to contact $S_2$. If desired, acceptor barrier 68 can be formed from an insulator which is thicker in the region outside of electrodes $S_3$ in the same manner that the injector barrier is thicker outside the device area. This will further ensure that there is no undesired electrical contact between conductor 70 and $S_3$.

Fig. 9 shows a top view of a layout for a double junction acceptor device such as that in Fig. 8. The bottom electrode is $S_1$, while the thin middle electrode is $S_2$. The top electrode is $S_3$. The additional thick metallurgy layer 70 is used to make contact to thin electrode $S_2$ and is shown in the side view of Fig. 8. The acceptor junction 68 is a duoble junction, while the injector junction 68 is formed between $S_1$ and $S_2$. The injector current flows into contact strip 70 and out of $S_1$. Layer 72 is an insulating layer which electrically insulates $S_1$ from $S_3$. It is, for example, a layer of SiO.

In Fig. 9, W is the minimum linewidth. Thus, this device layout occupies an area 21 $W^2$. This represents an improvement in density over the holey and stepped interferometers of the prior art. One disadvantage of the Quiteron is in the required control of the current densities $j_i$ and $j_a$ to within reasonable tolerances. However, this disadvantage may be rendered less severe due to the availability of gain, large discrimination factor, and high noise immunity.

## Applications of Quiteron

This device has applications in digital systems, analog systems, and in the study of the physics of non-equilibrium superconductivity. The technology necessary to make superconductive tunneling devices, such as Josephson tunneling devices, can be used to fabricate circuits of Quiterons. The following sections will describe the use of these devices in logic circuits, and as analog amplifiers.

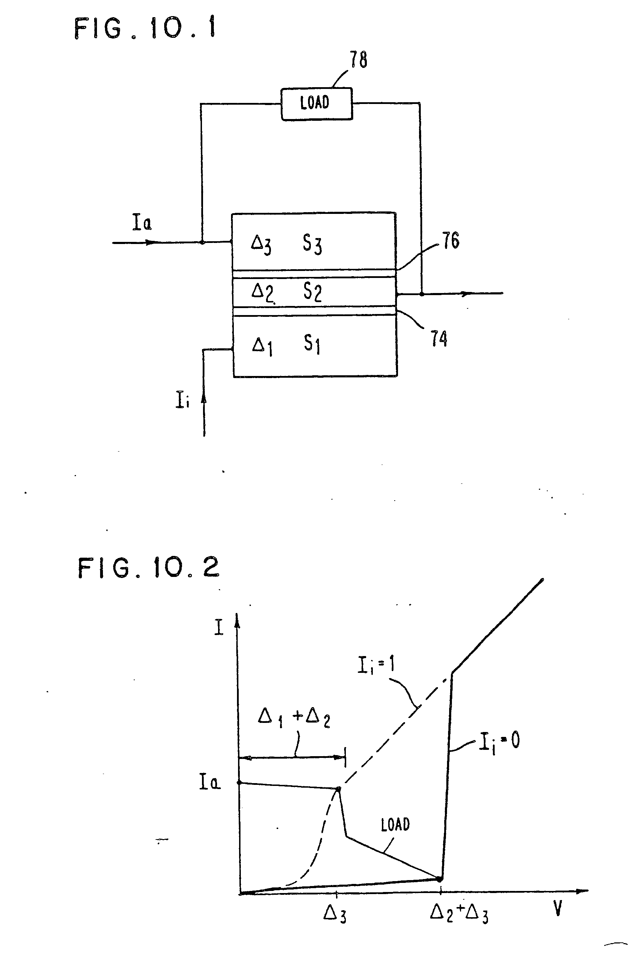

## Quiteron logic circuits (Figs. 10.1, 10.2, 11.1, 11.2, 12—18)

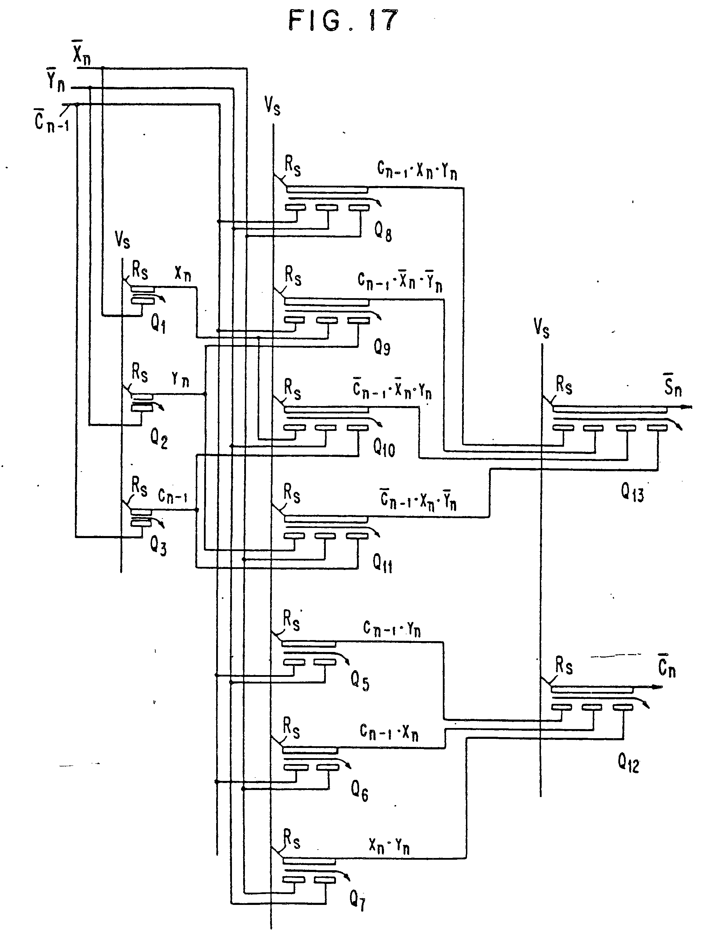

As will be apparent from the following, NOR logic circuits can be built using these devices. This provides advantages in fabrication/density/scaling over the Josephson device circuits, in which AND, OR, and INVERT blocks are needed to design complete logic circuits. Because the Quiteron is an inverting device, a NOR block can easily be designed, and this can be used to build a complete family of logic circuits. For this application the SJA configuratiion is more suitable than the DJA configuration. However, the DJA configuration has an advantage from the fabrication and metallurgical points of view. These configurations can be combined in a single circuit, as will be apparent from the full adder of the Fig. 17.

The ratio $\eta = P(0)/P(\infty) \gg 1$ has been mentioned to enhance the maximum gain, the discrimination ratio, and the noise immunity. In order to take advantage of $\eta$, certain constraints are applied to $\Delta_1$, $\Delta_2$, and $\Delta_3$ for both the SJA and DJA devices. For the SJA device

$$\Delta_3 \leq \Delta_1 + \Delta_2 < \Delta_2 + \Delta_3,$$

while for the DJA device

$$2\Delta_3 \leq \Delta_1 + \Delta_2 < 2(\Delta_2 + \Delta_3).$$

Fig. 10.1 shows an SJA configuration, while Fig. 10.2 shows the I-V characteristic. The ratio of the 1 voltage state to the 0 voltage state is

$$V(1)/V(0) = (\Delta_2 + \Delta_3)/(\Delta_1 + \Delta_2).$$

These voltages are indicated in Fig. 10.2 for the SJA device having an injector current $I_i$ and an acceptor bias current $I_a$. The injector junction 74 is located between $S_1$ and $S_2$ while the acceptor junction 76 is located between $S_2$ and $S_3$. A nonlinear load 78 is connected across the acceptor junction and can be, for example, another SJA device.

Since $\Delta_1 + \Delta_2 \sim \Delta_3$, $V(1)/V(0)$ is approximately $(\Delta_2/\Delta_3) + 1 \leq 1.5$, $\Delta_2/\Delta_3$ is at least equal to or greater than 0.5. Three different superconductors, preferably with $T_c > 4.2°K$, are therefore necessary. Table I lists possible sets of superconductors that may be used to implement the SJA configuration.

## TABLE I

| Set No. | $S_1$ | $\Delta_1$ | $T_{c1}$ | $S_2$ | $\Delta_2$ | $T_{c2}$ | $S_3$ | $\Delta_3$ | $T_{c3}$ |
|---------|-------|-----------|----------|-------|-----------|----------|-------|-----------|----------|
| 1 | PbTe | 1.19 | 6 | Nb | 1.525 | 9.2 | $Nb_3Sn$ | 3.25 | 17.2 |
| 2 | PbTe | 1.19 | 6 | $Nb_3Sn$ | 3.25 | 17.2 | $Nb_3Ge$ | 4.08 | 21.55 |
| 3 | Pb | 1.36 | 7.2 | Nb | 1.525 | 9.2 | $Nb_3Sn$ | 3.25 | 17.2 |
| 4 | Nb | 1.525 | 9.2 | $Nb_3Sn$ | 3.25 | 17.2 | $Nb_3Ge$ | 4.08 | 21.55 |
| 5 | Nb | 1.525 | 9.2 | Nb | 1.525 | 9.2 | $Nb_3Sn$ | 3.25 | 17.2 |
| 6 | Nb | 1.525 | 9.2 | Nb | 1.525 | 9.2 | $Nb_3Ge$ | 4.08 | 21.55 |

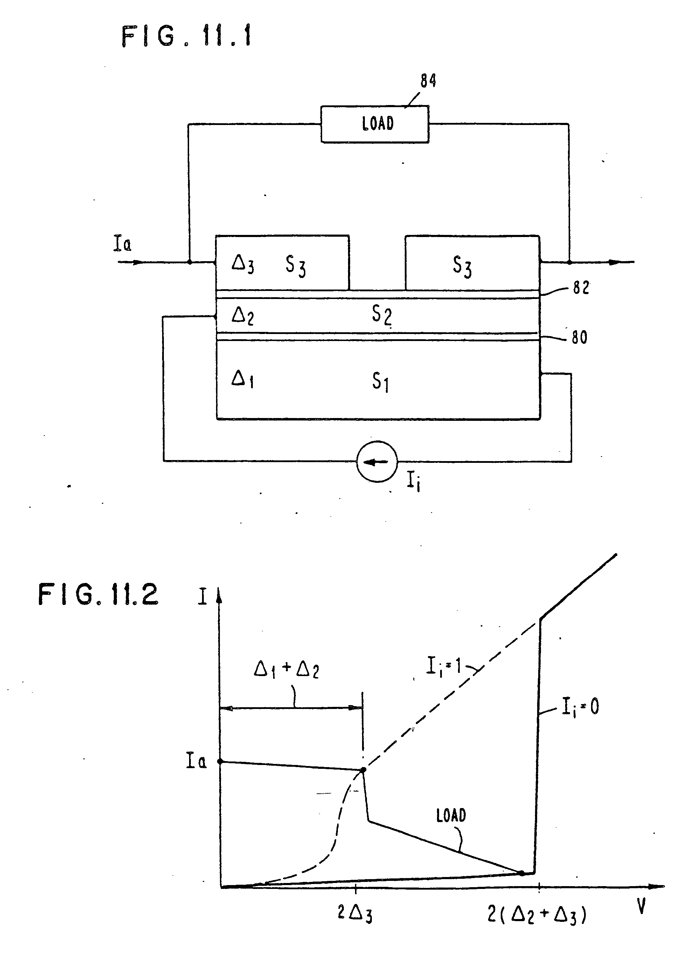

Fig. 11.1 shows a DJA configuration, while Fig. 11.2 gives the I-V characteristics and indicates the voltages when the device is in its 0 and 1 states. The injector junction 80 is located between $S_1$ and $S_2$, while the acceptor junction 82 is located between $S_2$ and $S_3$. A nonlinear load 84, preferably another DJA configuration, is connected across the acceptor. $I_i$ provides DC bias to the injector junction, while $I_a$ provides DC bias to the acceptor junction.

In order to take advantage of the discrimination when a nonlinear load is used,

$$2\Delta_3 \leq \Delta_1 + \Delta_2 < 2(\Delta_2 + \Delta_3).$$

Thus, $V(1)/V(0)$ is $2(\Delta_2 + \Delta_3)/(\Delta_1 + \Delta_2)$. The DJA configuration has a factor of two advantage in discrimination over the SJA configuration and therefore the three superconductors can be the same for the DJA device. If $\Delta_1 = \Delta_2 = \Delta_3$, $V(1)/V(0) = 2$.

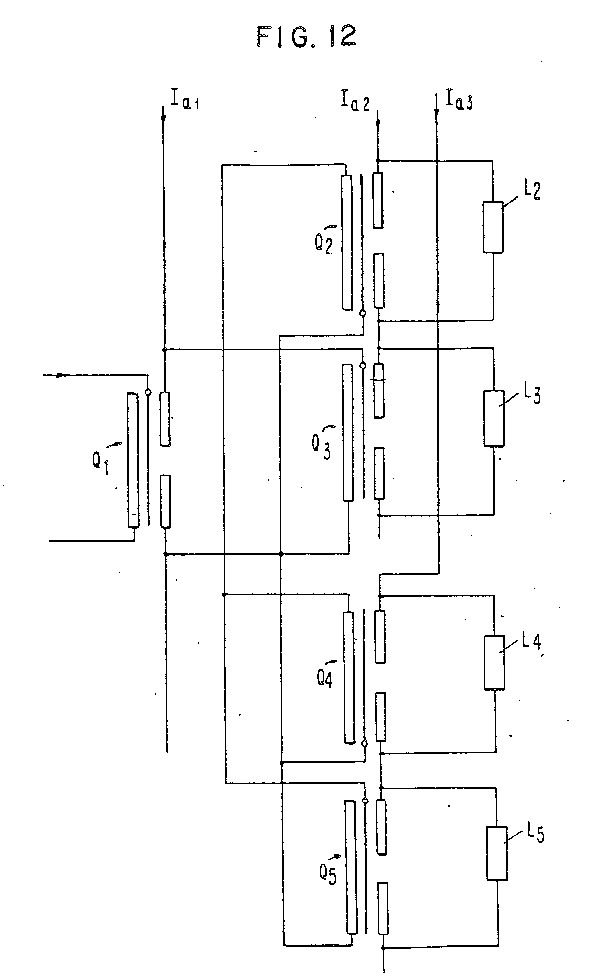

Fig. 12 shows DJA devices powered by current sources $I_{a1}$, $I_{a2}$, and $I_{a3}$ in order to obtain a fan-out of four. The DJA Quiterons are shown schematically, and are labelled $Q_1$, $Q_2$, $Q_3$, $Q_4$, and $Q_5$. The loads $L_2$, $L_3$, $L_4$, and $L_5$ are connected across devices $Q_2$—$Q_5$, respectively.

It would be ideal to string DJA devices in series by means of a single current source. However, because of undesirable current leakage paths, a multiplicity of current sources is required, as shown in Fig. 12. Each device is restricted to have a fan-out of two for each different current source. For example, device $Q_1$ drives the two devices $Q_2$ and $Q_3$ powered by $I_{a2}$, and drives devices $Q_4$ and $Q_5$ powered by $I_{a3}$, thus providing a total fan-out of four. This powering scheme is of limited utility because only simple logic functions can be implemented. An undesirable number of current sources is necessary in order to implement more complex functions.

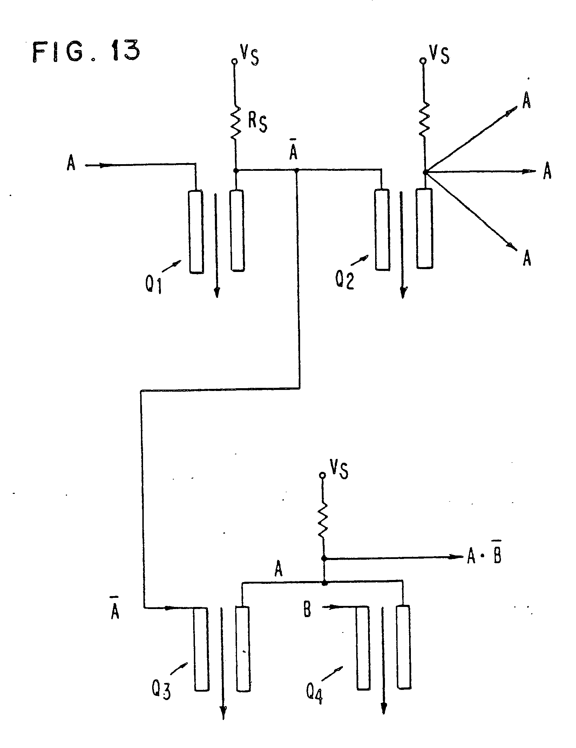

The SJA device configuration avoids the isolation problems encountered by the DJA device. This occurs because the center electrode is grounded, and hence current return paths to the input are eliminated. For example, Fig. 13 illustrates a parallel powering scheme which requires a single voltage bus $V_s$ and a power resistor $R_s$ for each device. This scheme dissipates more power than a series connected DJA configuration, but takes better advantage of Quiteron density. The power resistor $R_s$ can be made with a suitable tunnel junction, especially since the supply voltage $V_s$ is a DC voltage.

In Fig. 13, device $Q_1$ has an injector input A, and will provide an acceptor output $\overline{A}$ when A exceeds the threshold power density. Only when input $\overline{A}$ is present to device $Q_2$ will the outputs A be realized from $Q_2$.

$\overline{A}$ is also an input to device $Q_3$. Its output will be A, which is provided to the acceptor electrode of device $Q_4$. Only when input B is present to $Q_4$, will the output $\overline{B}$ be provided from $Q_4$. Thus, the presence of $\overline{A}$ to $Q_3$ at the same time that B is provided to $Q_4$ is required to produce the output A $\cdot \overline{B}$.

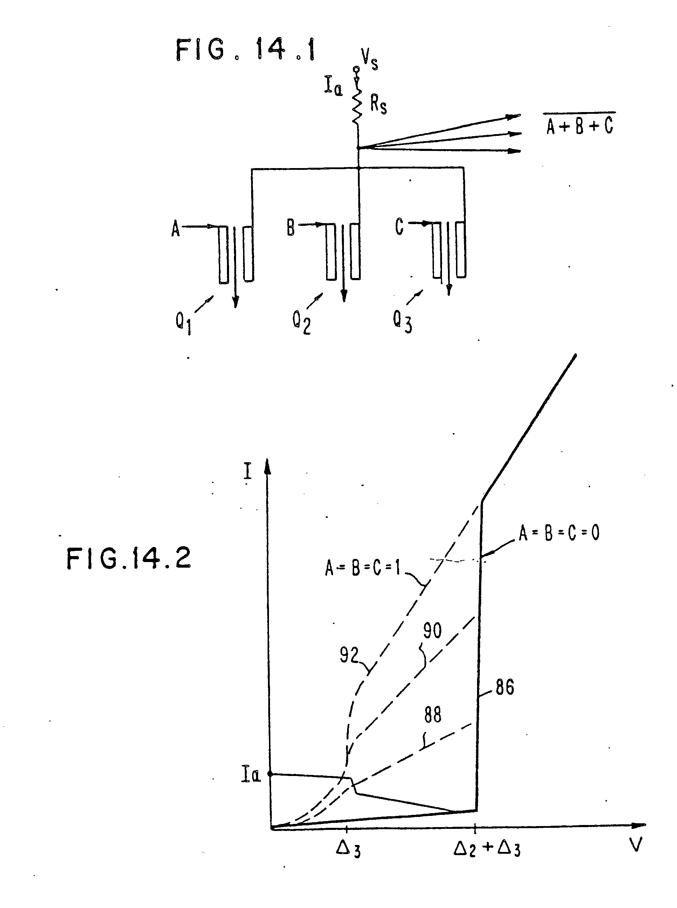

Fig. 14.1 shows a three input NOR circuit with Quiterons $Q_1$, $Q_2$, and $Q_3$. A single voltage bus delivers the power $V_s$ through a resistor $R_s$. Thus, acceptor current $I_a$ flows to each of the acceptors of devices $Q_1$—$Q_3$. Input A is provided to the injector of $Q_1$, input B is provided to the injector of $Q_2$, and input C is provided to the injector of $Q_3$. The presence of any input A, B, or C will provide an output $\overline{A}$ or $\overline{B}$ or $\overline{C}$, respectively.

The I-V characteristics of the three input NOR circuit of Fig. 14.1 are shown in Fig. 14.2. When all the inputs A, B, and C are in the "0" state, devices $Q_1$—$Q_3$ assume the equilibrium characteristics given by the solid curve 86, and nearly all of the current $I_a$ is delivered to the load (not shown). This load is the injector nonlinear characteristics of the fan-out Quiterons. If one or more of the inputs A, B, C are in the "1" state, the non-equilibrium characteristics represented by the dashed curves 88, 90, and 92 are developed, causing the load voltage to switch to $\Delta_3$ and the current to diminish to $\Delta_3/R_j$ (load). Curve 88 appears when one of the inputs is present while curve 90 appears if two inputs are present. Dashed curve 92 appears when all three inputs are present.

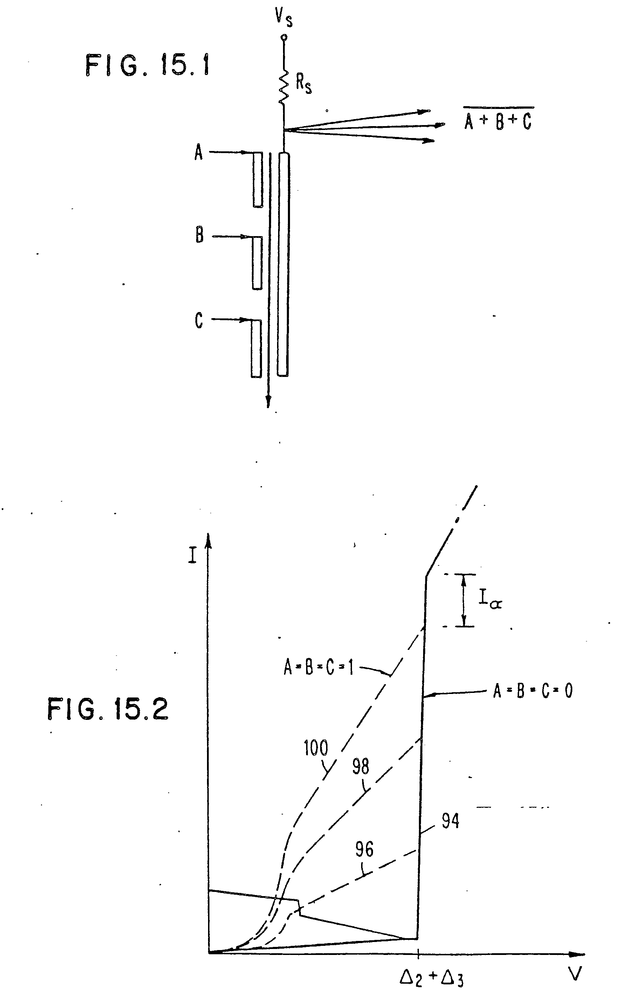

Fig. 15.1 shows a multi-injector NOR configuration which is nearly identical to the three input NOR circuit made of discrete Quiterons, as shown in Fig. 14.1. In the circuit of Fig. 15.1, a single acceptor is provided, while three separate injectors are provided, having inputs A, B, and C. A voltage bias $V_s$ is provided through resistor $R_s$ to the acceptor junction. When any of the inputs A, B, or C is present, the output $\overline{A}$ or $\overline{B}$ or $\overline{C}$, respectively, will be provided.

The difference between the circuits of Figs. 15.1 and 14.1 is evident in the I-V characteristics. The characteristic of Fig. 15.2 shows an additional current transition $I_a$ at $V=\Delta_2+\Delta_3$. This reflects the fact that the ratio of acceptor area $A_a$ to the injector area $A_i$ is larger than unity for the multi-injector configuration of Fig. 15.1. Therefore, this type of configuration may have a gain advantage as well as a density advantage over the single injector configuration of Fig. 14.1.

The I-V characteristics of Fig. 15.2 are otherwise the same as those of Fig. 14.2. Thus, solid curve 94 is the curve followed when no input is present, dashed curve 96 is the curve followed when one input is present, dashed curve 98 is the one followed when two inputs are present, and dashed curve 100 is the curve followed when all three inputs are present.

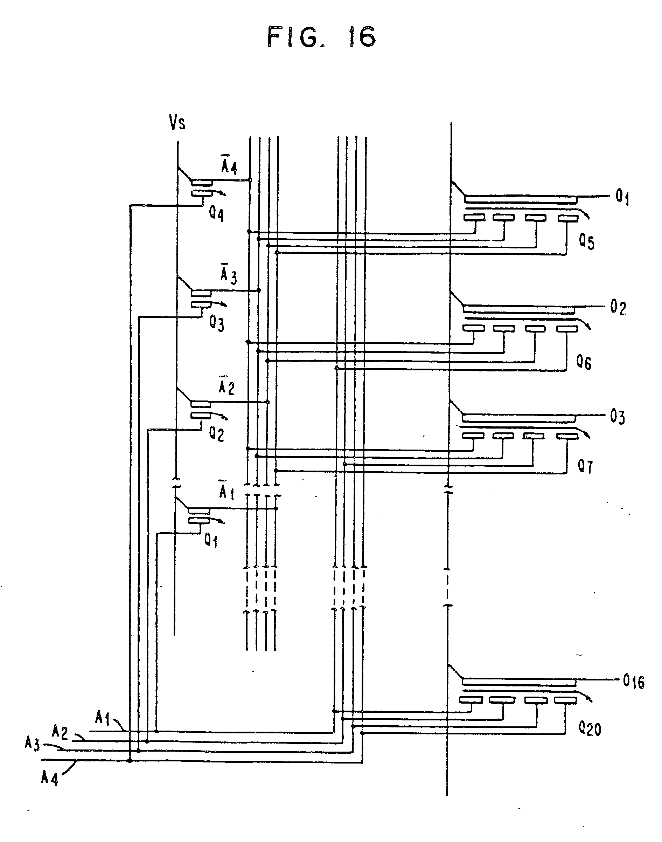

Fig. 16 shows a four-bit decoder using parallel powered NOR blocks. The circuit is comprised of the single injector SJA devices $Q_1$, $Q_2$, $Q_3$, $Q_4$, etc. Multi-injector SJA devices $Q_5$, $Q_6$, $Q_7$,...,$Q_{20}$ are also provided. The acceptor outputs of $Q_5$—$Q_{20}$ provide the decoder outputs.

The decoder structure of Fig. 16 is similar to other decoders known in the art. Depending upon the injector inputs $A_1$, $A_2$, $A_3$, and $A_4$, devices $Q_1$—$Q_4$ will provide outputs $\overline{A}_1$—$\overline{A}_4$. The outputs of $Q_1$—$Q_4$, as well as the inputs $A_1$—$A_4$, are provided in different combinations to the multiple injectors of $Q_5$—$Q_{20}$. As is well known in the decoder art, depending upon the combinations of the four inputs, 16 outputs $0_1$—$0_{16}$ can be obtained.

Fig. 17 shows a one-bit full adder using both SJA and DJA device configurations. The design of this circuit is similar to the design of other full adders and provides as an output the complement $\overline{S}_n$ of the sum signal and the complement $\overline{C}_n$ of the carry signal. The adder is comprised of three SJA devices $Q_1$—$Q_3$ at the circuit input, and three double injector Quiterons $Q_5$—$Q_7$. Additionally, five triple-injector Quiterons $Q_8$—$Q_{12}$ are used as well as one quadruple injector Quiteron $Q_{13}$. The acceptor junctions of all the Quiterons are provided with the same supply voltage $V_s$ through resistors $R_s$.

Devices $Q_1$—$Q_3$ provide the complements of the inputs $\overline{X}_n$, $\overline{Y}_n$, and $\overline{C}_{n-1}$. The outputs from the acceptors of $Q_1$—$Q_3$ are applied to the injector junctions of Quiterons $Q_9$—$Q_{11}$. Devices $Q_5$—$Q_8$ receive as injector inputs various combinations of the circuit inputs $\overline{X}_n$, $\overline{Y}_n$, and $\overline{C}_{n-1}$. The acceptor outputs of devices $Q_8$—$Q_{11}$ are applied as injector inputs to $Q_{13}$ to develop the complement $\overline{S}_n$, while the acceptor outputs of devices $Q_5$—$Q_7$ are the injector inputs to $Q_{12}$, to provide the complement $\overline{C}_n$ of the carry signal.

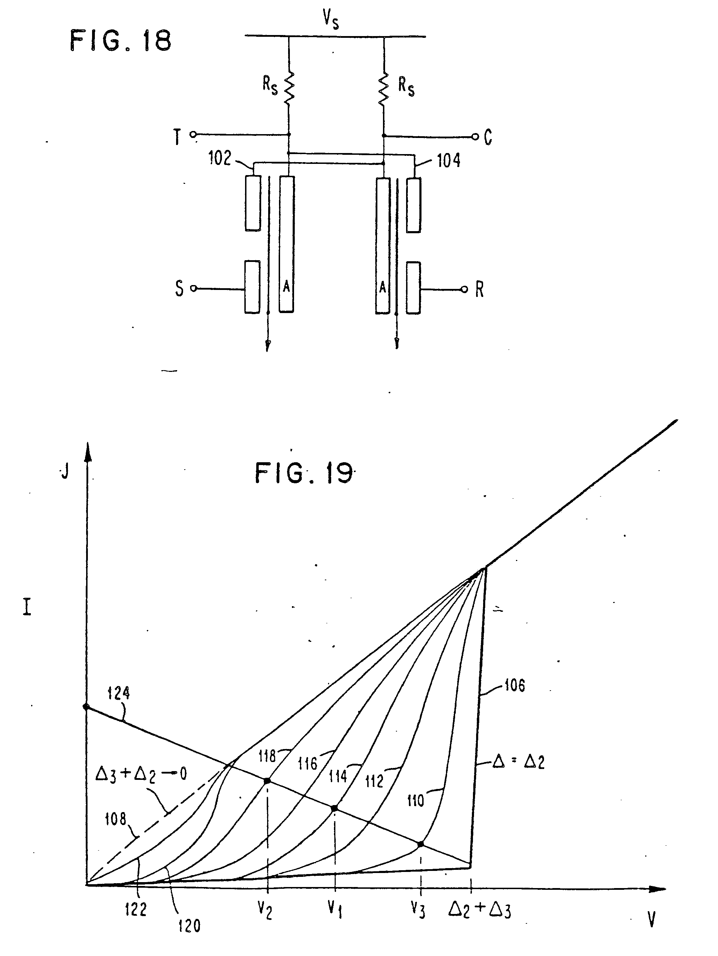

Since a Quiteron is an inverter device, it can be utilized to design a flip-flop circuit, such as the NOR flip-flop shown in Fig. 18. A circuit of this type can be used to provide memory latches, as well as memory arrays when an appropriate selection scheme is developed.

The flip-flop is comprised of two double injector Quiterons $Q_1$ and $Q_2$ which are cross-coupled to one another. A DC bias $V_s$ is applied to the acceptor junction of each device $Q_1$ and $Q_2$ through resistances $R_s$. A SET signal S is applied to one injector input of $Q_1$, while a RESET signal R is applied to one injector input of $Q_2$. The other injector input of $Q_1$ is connected, via line 102, to the acceptor output of $Q_2$, while the second injector input to $Q_2$ is connected to the acceptor output of $Q_1$ via electrical connection 104. The operation of the flip-flop is the same as conventional flip-flops, a true signal T and a complement signal C being provided at the acceptor outputs of $Q_1$ and $Q_2$, respectively.

Analog amplifier

The Quiteron structure can be used to provide analog amplification of the input signals to its injector junction. For this use, it is desirable to change the superconducting gap drastically, but it is not necessary to reduce the gap to zero. In fact, if the gap is reduced to zero, a linear output will not be obtained. Since linearity is important in an amplifier, the input signal should be less than that which would cause the gap of the superconductor into which quasi-particles are injected from vanishing.

Fig. 19 shows the current-voltage characteristics of a Quiteron device used as an analog amplifier. The solid curve 106 is the I-V characteristic when the gap $\Delta=\Delta_2$. That is, this is the equilibrium condition. The dashed curve 108 is the curve which would result if $\Delta_3+\Delta_2\rightarrow0$. As mentioned, a threshold type of operation is necessary for digital switch applications, but this threshold may not be reached when amplification is desired.

Depending upon the magnitude of the input signal to the injector, a family of curves 110, 112, 114, 116, 118, 120, and 122 can be developed. As $\Delta_2$ diminishes, the I-V curves change from 106 and 110, then to 112, etc.

In operation, the amplifier can be biased at a voltage $V_1$, which corresponds to a power input $P\sim1/2\ P_c$, and the presence of an input signal causes an output which is determined by the linear voltage of the load line 124. Thus, output voltages from $V_2$ to $V_3$ can be obtained depending upon the input signal magnitude. Large current amplification can be obtained in this way, in contrast with the amplifier of U.S. 4,157,555 in which $P\ll P_c$. It is not possible to obtain large signal gain in that prior art transistor. In contrast with this, the superconducting gap is drastically changed to provide a full family of curves 110—122 in order to provide a large gain.

Examples

Although the Quiteron embodiments presented here have been described in detail with respect to the relationships between the superconducting gaps of the different electrodes, it is readily apparent that Quiteron-type devices can be built without maximizing the discrimination ratio, gain, and noise immunity. Examples have been shown for the types of superconductors and their alloys which yield different superconducting gaps. Still further, it is possible to use normal (i.e., non-superconducting) materials for either the top or bottom electrode, or both. However, it is desirable that $S_3$ be a superconductor since this will provide the best gain, discrimination, etc. However, by choosing appropriate superconductors, the Quiteron device characteristics can be enhanced as described previously.

In the preferred embodiments, injection of quasi-particles from a tunnel barrier provides over injection of quasi-particles into the superconductor whose gap is to change. This type of injection input can be modified to use a combination of inputs, such as electrical inputs and photon beams. Thus, a Quiteron can be fabricated in which an electrical signal is applied to the injector junction as well as a photon beam. Also, the input excitation can be due to only the photon beam in order to provide a full optical transistor.

The thicknesses of the various electrode layers are chosen with respect to the device characteristics that are required. In particular, the thin superconducting electrode $S_2$ whose superconducting gap must be drastically altered should be sufficiently thin that this can be achieved without the application of unduly large signals. A representative thickness for the electrode $S_2$ is 50—100 nm. This is dictated by the fact that the threshold power density $P_c$ must be reached of reasonable power levels. The design proceeds as follows: an $S_2$ thickness of, for example, 50 nm is chosen to obtain $P_c\approx1$ watt/cm$^2$ for lead at

$$V_1=2(\Delta_2+\Delta_3).$$

This fixes the injector current density $j_i$ to about 250—500 A/cm$^2$. The acceptor current density can now be chosen to obtain the desired gain which is given by $\sim j_a/j_i\gtrsim100$, for example.

The thicknesses of the tunnel barriers are chosen to provide appropriate ratios of the current densities $j_a$ and $j_i$. While the presence of Josephson tunneling current through either of the junctions is not required for operation of this device, tunnel barriers can be provided where Josephson current is present. This current could be used to provide a device with three states, which is capable of latching. Representative values for the thicknesses of the injector and acceptor tunnel junctions are such that a current density ratio $j_a/j_i\gtrsim100$ is obtained. Devices employing Josephson currents, and devices using different biasing will now be described.

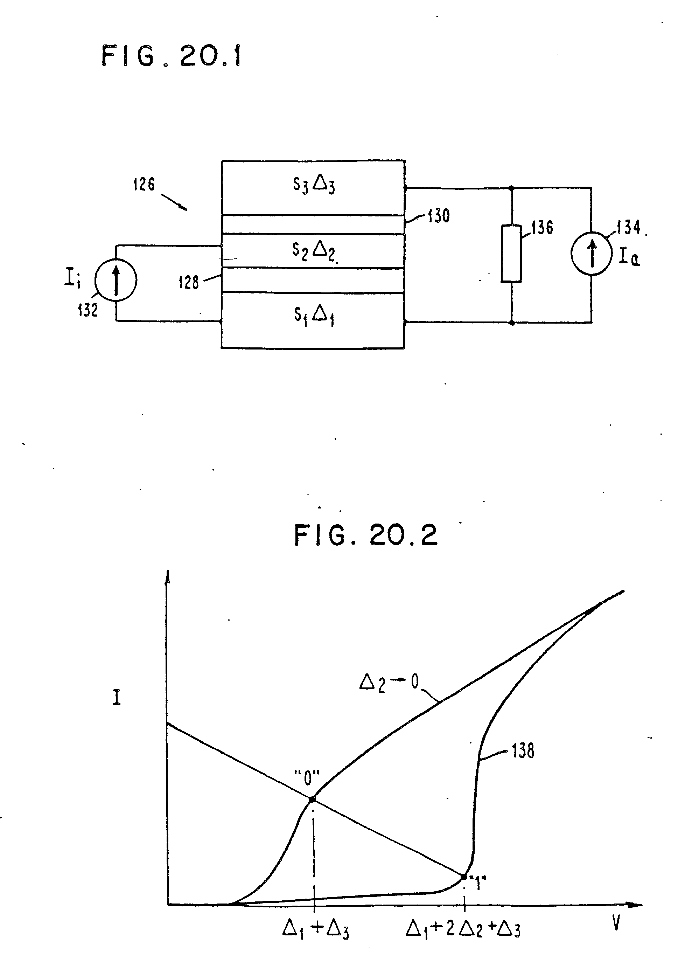

Quiteron with different biasing (Figs. 20.1 and 20.2)

For illustrative purposes, a SJA device is shown in Fig. 20.1, while its I-V characteristic is shown in Fig. 20.2. Quiteron 126 is comprised of three electrodes $S_1$, $S_2$, and $S_3$, the injector junction 128, and the acceptor junction 130. Current source 132 provides injection current $I_i$ while the acceptor junction 130 is biased by current source 134, which produces current $I_a$. In contrast with the previously shown biasing schemes, load 136 is connected across $S_1$ and $S_3$ in this embodiment.

In Fig. 20.2, the equilibrium curve 138 has a current transition at $\Delta_1+2\Delta_2+\Delta_3$, in contrast with the usual equilibrium curve for a SJA device, which has a current transition at $\Delta_2+\Delta_3$. Thus, a greater diacrimination can be obtained between the "1" and "0" states. Here, the total equilibrium voltage curve depends upon the voltages across both the injector and acceptor barriers. For this reason, a larger voltage swing can be obtained than with the other SJA embodiments. However, the voltage swing is not necessarily greater than that which is obtained with a DJA structure, and the biasing technique of Fig. 20.1, is not as satisfactory from hhe standpoint of isolation between the output and the input.

Josephson state Quiterons (Figs. 21.1, 21.2, 22, and 23)

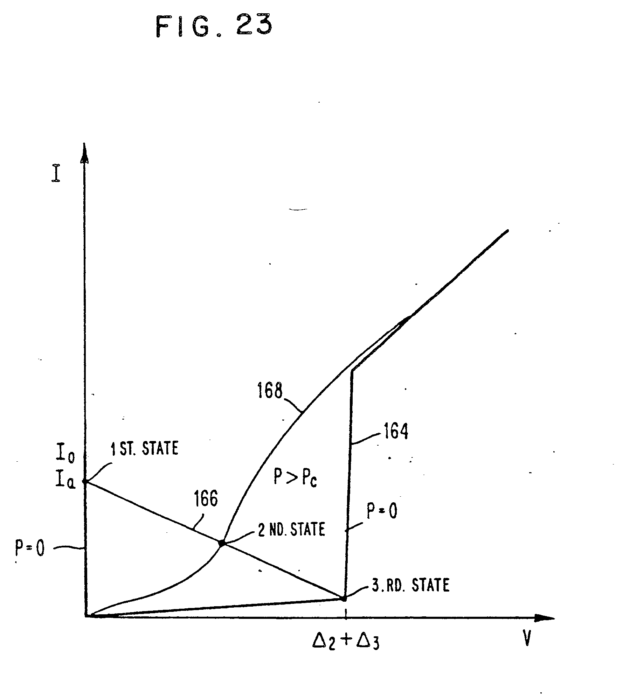

These embodiments describe switching between multiple output states, at least one of which is a Josephson state exhibiting 0-voltage current. One of these embodiments (Fig. 23), three distinguishable output states are provided.

In more detail, Fig. 21.1 shows a SJA structure including electrodes $S_1$, $S_2$, and $S_3$. $S_2$ and $S_3$ are superconductors, while $S_1$ can be a superconductor or a normal material. Injector tunnel barrier 140 is located between $S_1$ and $S_2$, while acceptor tunnel barrier 142 is located between $S_2$ and $S_3$. A linear load 144 is connected to the acceptor electrode $S_3$. Injector current $I_i$ flows into $S_1$ and out of $S_2$, while the acceptor is biased by current $I_a$ which flows into $S_3$ and out of $S_2$. If barrier 142 is sufficiently thin, a zero-voltage current will tunnel through this barrier in accordance with the Josephson effect. As an alternative, the acceptor can be comprised of a weak link if one of the device output states is a zero-voltage current. For this embodiment the term "tunnel junction" is meant to include a weak link device as well as one having electrodes separated by a tunnel barrier, i.e., any device exhibiting a Josephson current.

The I-V characteristics of the Quiteron of Fig. 21.1 are shown in Fig. 21.2. Different curves are obtained for different values of the Stewart-McCumber hysteresis parameter $\beta$. This parameter is known in the art and is one which measures the amount of hysteresis obtained when the current-voltage characteristics are plotted. A junction will exhibit hysteretic effects when $\beta \gg 1$ and will be non-hysteretic for values of $\beta \leq 1$. As is known, $\beta$ is given by the following expression:

$$(8) \qquad \beta = \frac{2\pi}{\phi_0} I_0 R^2 C_j$$

where $\phi_0$ is a single flux quantum, $I_0$ is the Josephson critical current through tunnel barrier 142, R is the total junction resistance, and $C_j$ is the junction capacitance.

Curve 146 is the equilibrium curve of the Quiteron where $\beta \ll 1$ (i.e., a hysteretic junction) while curve 150 represents the equilibrium state when $\beta \ll 1$. When $P > P_c$ is applied, the characteristic switches to that depicted by curve 148 or curve 152, depending on the amount of power overdrive.

In Fig. 21.2, two load lines having slopes $R_{L1}$ and $R_{L2}$ are shown. A zero-voltage Josephson state can occur when Josephson current tunnels through the acceptor junction. This occurs for $\beta \ll 1$. As P increases to $P_c$, the device switches from a Josephson state to a state given by the intersection of the load line and curve 152. Thus, this Quiteron is non-inverting, and non-latching.

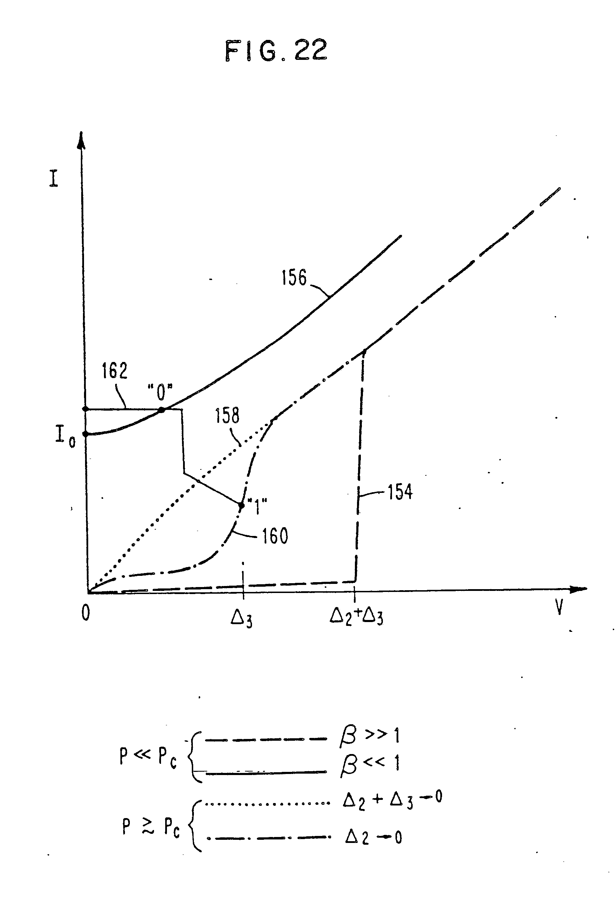

Fig. 22 shows the I-V characteristics of a Quiteron exhibiting a 0-voltage Josephson state, where the load is now a nonlinear load, such as that represented by another Quiteron device. Equilibrium curve 154 represents the I-V characteristic for a junction having $\beta \gg 1$ (hysteretic), while the solid line curve 156 represents the equilibrium curve for a junction in which $\beta \ll 1$ (non-hysteretic). Curves 154 and 156 are the equilibrium curves when $P \ll P_c$. Curve 158 is the usual curve when the hysteretic junction is switched to $\Delta_2+\Delta_3=0$, while curve 160 is the I-V characteristic when a non-hysteretic junction has $\Delta_2=0$. Nonlinear load line 162 intersects curve 156 at a point corresponding to a binary "0", and intersects curve 160 at a point representing a binary "1" state.

The device of Fig. 22 is non-inverting, and non-latching.

Fig. 23 shows an I-V curve for the Quiteron of Fig. 21.1 biased to have three states, where one state is a Josephson zero voltage state. The Quiteron of Fig. 21.1 has an equilibrium curve 164 and, if the acceptor barrier is sufficiently thin and there is magnetic shielding, a Josephson current can flow through the acceptor barrier. For the Quiteron of Fig. 23, $\beta \gg 1$, and the load is linear, as shown by linear load line 166. Curve 168 represents the situation when $P > P_c$.

When P=0, and $I < I_0$ ($I_0$ is the Josephson critical current), a Josephson zero-voltage state (first state) can exist. When the Quiteron is switched by an input power $P > P_c$, $\Delta_2$ vanishes and another state (second state) exists at the intersection of the load line and curve 168. Now, when the power is removed, the Quiteron switches to a third state represented by the intersection of load line 166 and curve 164. In order to retrieve the first state, the current $I_a$ has to be removed and applied again. Therefore, this is a non-inverting and latching device.

## Claims

1. Three terminal superconducting tunnel junction device comprising three conducting electrodes $(S_1, S_2, S_3)$ which are separated from one another by two tunnel barriers (32, 34) to form two tunnel junctions, characterized in that the first, acceptor junction $(S_3, 34, S_2)$, at least one of its electrodes $(S_2)$ being a superconductor, exhibits a threshold power density at which an excess number of quasi-particles exists causing the superconducting gap of said superconducting electrode to vanish, that the second, injector junction $(S_2, 32, S_1)$ serves as a means for injecting power of a magnitude up to the order of said threshold power density into said superconducting electrode $(S_2)$ causing its superconducting gap to change drastically, the superconducting electrode $(S_2)$ being the electrode common to both junctions, and in that load means $(R_L)$ are connected across said first junction for receiving the output of said first tunnel junction.

2. A device as claimed in claim 1, characterized in that said three conducting electrodes $(S_1, S_2, S_3)$ consist of superconductor material.

3. A device as claimed in claim 1, characterized in that at least one of the two electrodes $(S_1, S_3)$ that are not common to both junctions consists of non-superconductor material.

4. A device as claimed in claim 1, characterized in that said first junction is comprised of a plurality of tunnel junctions $(S_3, S_3')$.

5. A device as claimed in claim 1, characterized in that said second junction is comprised of a plurality of tunnel junctions.

6. A device as claimed in claim 1, characterized in that the tunnel barrier (34) of said first junction is comprised of an insulating material exhibiting a sharp current transition in its current-voltage characteristic.

7. A device as claimed in claim 1, characterized in that the tunnel barrier (34) of said first junction is sufficiently thin to permit zero-voltage Josephson current to tunnel therethrough.

8. A device as claimed in claim 1, characterized in that said load means $(R_L)$ is another of said superconducting tunnel junction devices.

## Patentansprüche

1. Supraleitendes Bauelement mit Tunnelübergängen und drei Anschlüssen, bestehend aus drei leitenden Elektroden $(S_1, S_2, S_3)$, welche durch zwei Tunnelbarrieren (32, 34) voneinander getrennt sind, somit zwei Tunnelübergänge bildend, dadurch gekennzeichnet, dass der erste, der Akzeptor-Uebergang $(S_3, 34, S_2)$, bei dem wenigstens eine Elektrode $(S_2)$ aus einem Supraleiter besteht, eine Schwellenenergiedichte aufweist, bei der ein Ueberschuss an Quasi-Partikeln besteht, der die Energielücke der supraleitenden Elektrode zu Null werden lässt, dass der zweite, der Injektor-Uebergang $(S_2, 32, S_1)$, zum Injizieren von Energie bis zur Grössenordnung der genannten Schwellenenergiedichte in die supraleitende Elektrode $(S_2)$ dient, wodurch sich deren Energielücke drastisch verändert, dass die genannte supraleitende Elektrode $(S_2)$ die beiden Uebergängen gemeinsame Elektrode ist, und dass parallel zum ersten Uebergang eine Last $(R_L)$ zur Aufnahme des Ausgangs dieses Uebergangs geschaltet ist.

2. Ein Element gemäss Anspruch 1, dadurch gekennzeichnet, dass die drei Elektroden $(S_1, S_2, S_3)$, aus supraleitendem Material bestehen.

3. Ein Element gemäss Anspruch 1, dadurch gekennzeichnet, dass wenigstens eine der beiden Elektroden $(S_1, S_3)$, die nicht beiden Uebergängen gemeinsam sind, aus supraleitendem Material besteht.

4. Ein Element gemäss Anspruch 1, dadurch gekennzeichnet, dass der erste Uebergang aus einer Mehrzahl von Tunnelübergängen $(S_3, S_3')$ gebildet wird.

5. Ein Element gemäss Anspruch 1, dadurch gekennzeichnet, dass der zweite Uebergang aus einer Mehrzahl von Tunnelübergängen gebildet wird.

6. Ein Element gemäss Anspruch 1, dadurch gekennzeichnet, dass die Tunnelbarriere (34) des ersten Uebergangs aus einem isolierenden Material besteht, das in der Strom-Spannungs-Kennlinie einen markanten Stromübergang bewirkt.

7. Ein Element gemäss Anspruch 1, dadurch gekennzeichnet, dass die Tunnelbarriere (34) des ersten Uebergangs hinreichend dünn ist, um einen Josephson-Tunnelstrom bei der Spannung Null zu ermöglichen.

8. Ein Element gemäss Anspruch 1, dadurch gekennzeichnet, dass die Last $(R_L)$ aus einem weiteren Element mit supraleitendem Tunnelübergang besteht.

## Revendications

1. Dispositif supraconducteur à junctions tunnel à trois bornes, comprenant trois électrodes conductrices $(S_1, S_2, S_3)$ qui sont séparées les unes des autres par deux barrières tunnel (32, 34) pour former deux jonctions tunnel, caractérisé en ce que la première jonction, d'acceptation $(S_3, 34, S_2)$, au moins une de ses électrodes $(S_2)$ étant un supraconducteur, présente une densité de puissance de seuil à laquelle il existe un nombre de quasi-particules en excès provoquant la disparition de l'intervalle de supraconduction de ladite électrode supraconductrice, en ce que la deuxième jonction d'injection $(S_2, 32, S_1)$, sert comme moyen d'injection de puissance d'une grandeur atteignant l'ordre de ladite densité de puissance de seuil dans ladite électrode supraconductrice $(S_2)$ provoquant une très forte variation de son intervalle de supraconduction, l'électrode supraconductrice $(S_2)$ étant l'électrode commune aux deux jonctions, et en ce que des moyens de charge (R_L) sont raccordés de part et d'autre de la première jonction pour recevoir la sortie de la première jonction tunnel.

2. Dispositif suivant la revendication 1, caractérisé en ce que les trois électrodes conductrices (S_1, S_2, S_3) sont en matière supraconductrice.

3. Dispositif suivant la revendication 1, caractérisé en ce qu'au moins une des deux électrodes (S_1, S_3) qui ne sont pas communes aux deux jonctions est en matière non supraconductrice.

4. Dispositif suivant la revendication 1, caractérisé en ce que la première jonction est composée d'une pluralité de jonctions tunnel (S_3, S_3').

5. Dispositif suivant la revendication 1, caractérisé en ce que ladite deuxième jonction est composée d'une pluralité de jonctions tunnel.

6. Dispositif suivant la revendication 1, caractérisé en ce que la barrières tunnel (34) de ladite première jonction est en une matière isolante présentant une brusque transition de courant dans sa caractéristique courant-tension.

7. Dispositif suivant la revendication 1, caractérisé en ce que la barrière tunnel (34) de ladite première jonction est suffisamment mince pour permettre à un courant Josephson à tension nulle de la traverser par effet tunnel.

8. Dispositif suivant la revendication 1, caractérisé en ce que les moyens de charge (R_L) sont constitués d'un autre dispositif supraconducteur à jonctions tunnel.

# FIG. 1.1
PRIOR ART

# FIG. 1.2

NORMALIZED
ENERGY GAP
$\Delta(\eta)/\Delta(0)$

NORMALIZED EXCESS QUASIPARTICLE DENSITY $\eta$

$I_T$

FIG. 1.3

# FIG. 2.1

$S_1, \triangle_1$

20

$V_T$

$+$

$-$

$S_2, \triangle_2$

$I_T$

# FIG. 2.2

$P_c(0) \equiv P_T$

$P_c(\epsilon)$

$P_c(\infty)$

1   2   3   4

$\epsilon = e\,V_{TC}/(\triangle_1 + \triangle_2)$

FIG. 3.1

FIG. 3.2

FIG. 4.2

4

# F I G. 4.3

0 081 007

# FIG. 5.1

FIG. 5.2

FIG. 6

FIG. 7

# FIG. 8

# FIG. 9

# FIG.10.1

# FIG.10.2

FIG.11.1

FIG.11.2

# FIG. 12

FIG. 13

FIG. 14.1

FIG.14.2

# FIG. 15.1

$$\overline{A + B + C}$$

# FIG. 15.2

# FIG. 16

FIG.17

FIG. 18

FIG. 19

FIG. 20.1

FIG. 20.2

FIG. 21.1

$I_a$

144

$S_3, \Delta_3$

142

$S_2, \Delta_2$

140

$I_i$

$S_1, \Delta_1$

I

150

$I_a$ "0"

$I_0$

148

RL1

146

152

RL2

"1"

$\Delta_3$   $\Delta_2 + \Delta_3$

V

FIG. 21.2

$- - -$  $\beta \gg 1$

$---$  $\beta \ll 1$

$P \gtrsim P_c \begin{cases} \cdots\cdots & \Delta_2 + \Delta_3 \to 0 \\ -\cdot-\cdot- & \Delta_2 \to 0 \end{cases}$

# FIG. 22

# FIG. 23